# EUROPÄISCHE PATENTSCHRIFT

(11) **EP 3 644 382 B1**
(45) Veröffentlichungstag und Bekanntmachung des Hinweises auf die Patenterteilung: **03.08.2022**
(21) Anmeldenummer: 19204987.2
(22) Anmeldetag: 24.10.2019
(51) Int. Cl.: H01L 39/24

(54) **MONOFILAMENT ZUR HERSTELLUNG EINES NB3SN-HALTIGEN SUPRALEITERDRAHTS, INSBESONDERE FÜR EINE INTERNE OXIDATION**
MONOFILAMENT FOR PRODUCING AN NB3SN-CONTAINING SUPERCONDUCTOR WIRE, ESPECIALLY FOR INTERNAL OXIDATION
MONOFILAMENT DESTINÉ À LA FABRICATION D'UN FIL SUPERCONDUCTEUR CONTENANT DU NB3SN, EN PARTICULIER POUR UNE OXYDATION INTERNE

(30) Priorität: 26.10.2018 DE 102018126760
(43) Veröffentlichungstag der Anmeldung: 29.04.2020
(73) Patentinhaber: Bruker EAS GmbH, 63450 Hanau (DE)
(72) Erfinder: Bühler, Carl, 63505 Langenselbold (DE); Abächerli, Vital, 63526 Erlensee (DE); Sailer, Bernd, 63755 Alzenau (DE); Schlenga, Klaus, 76149 Karlsruhe (DE); Thöner, Manfred, 63599 Biebergemünd (DE); Wanior, Matheus, 63571 Gelnhausen (DE)
(74) Vertreter: Kohler Schmid Möbus Patentanwälte

(56) Entgegenhaltungen:
- EP-A1- 1 993 107
- EP-A1- 2 779 258
- WO-A2-2015/175064
- X. XU ET AL: "Refinement of Nb 3 Sn grain size by the generation of ZrO 2 precipitates in Nb 3 Sn wires", APPLIED PHYSICS LETTERS, Bd. 104, Nr. 8, 24. Februar 2014 (2014-02-24), Seite 082602, XP55669132, US ISSN: 0003-6951, DOI: 10.1063/1.4866865
- XINGCHEN XU ET AL: "Internally Oxidized Nb 3 Sn Strands with Fine Grain Size and High Critical Current Density", ADVANCED MATERIALS, Bd. 27, Nr. 8, 1. Februar 2015 (2015-02-01), Seiten 1346-1350, XP55669133, DE ISSN: 0935-9648, DOI: 10.1002/adma.201404335

## Beschreibung

Die Erfindung betrifft ein Monofilament zur Herstellung eines Nb₃Sn-haltigen Supraleiterdrahts,
wobei das Monofilament umfasst:
   - einen Pulverkern, enthaltend ein Sn-haltiges Pulver,
   - ein Reaktions-Rohr aus einer Nb-Legierung, enthaltend Nb und wenigstens eine weitere Legierungskomponente X,
wobei der Pulverkern innerhalb des Reaktions-Rohrs angeordnet ist,
wobei im Monofilament weiterhin wenigstens eine Quelle Q für wenigstens eine Partnerkomponente Pk enthalten ist,
wobei eine jeweilige Quelle Q eine oder mehrere Quellstrukturen an einer einheitlichen radialen Position im Monofilament umfasst;
wobei die Legierungskomponente X und die Partnerkomponente Pk so gewählt sind, dass sie bei einem Reaktionsglühen des Monofilaments, bei dem Sn aus dem Pulverkern und Nb aus dem Reaktionsrohr zu Nb₃Sn reagieren, Ausscheidungen XPk bilden können.

Ein solches Monofilament ist aus der WO 2015/175064 A2 bekannt geworden.

Supraleitermaterialien können einen elektrischen Strom verlustfrei tragen, was in verschiedenen technischen Anwendungen genutzt werden kann, beispielsweise zur Erzeugung starker Magnetfelder mit supraleitenden Spulen. Ein in technischen Anwendungen häufig eingesetztes supraleitendes Material ist Nb₃Sn. Zur Erzeugung von supraleitenden Nb₃Sn-haltigen Drähten werden typischerweise Halbzeugdrähte gefertigt, die Nb und Sn enthalten und in eine gewünschte Form für die technische Anwendung gebracht werden, und sodann einem Reaktionsglühen unterzogen werden. Dabei entsteht die supraleitende Nb₃Sn-Phase. Bei den Halbzeugdrähten werden verschiedene Typen unterschieden, insbesondere die so genannten Tube-type Halbzeugdrähte, die Powder-in-tube Halbzeugdrähte oder auch die Rod-Restack-Prozess Halbzeugdrähte, vgl. für letztere z.B. US 7,585,377 B2. Die Herstellverfahren und die Prozesse beim Reaktionsglühen verlaufen für die verschiedenen Typen von Halbzeugdrähten teilweise sehr unterschiedlich.

Die supraleitende Stromtragfähigkeit von Nb₃Sn-haltigen Drähten hängt insbesondere vom Gefüge der Nb₃Sn-Phase ab. Eine geringe mittlere Korngröße, also ein feineres Gefüge, verbessert die supraleitende Stromtragfähigkeit. Um ein feineres Gefüge zu erreichen sind verschiedene Maßnahmen bekannt geworden, beispielsweise eine geringe Temperatur beim Reaktionsglühen, unterstützt durch Zusatz von bestimmten Elementen wie Kupfer, wodurch die Temperatur, bei der sich die Nb₃Sn-Phase bildet, herabgesetzt werden kann.

Eine weitere Maßnahme, um ein feineres Gefüge der Nb₃Sn-Phase zu erhalten, ist die so genannte interne Oxidation (internal oxidation). Bei der internen Oxidation werden bei der Wärmebehandlung oxidische Ausscheidungen erzeugt. Diese dienen als Nukleationskeime in der Phasenbildung des Nb₃Sn, was in einem feineren Nb₃Sn-Gefüge resultiert. Zusätzlich können die Ausscheidungen das Kornwachstum der Nb₃Sn-Phase während der Wärmebehandlung hemmen. Durch die resultierende kleinere Korngröße kann eine verbesserte Stromtragfähigkeit eines entsprechenden Supraleiterdrahts erhalten werden, vgl. z.B. A. Godeke, Ph.D. Thesis "Performance Boundaries in Nb3Sn Superconductors", University of Twente, Enschede, NL (2005), chapter 2.7.

Ausscheidungen können auch als künstliche Pinningzentren (APCs) wirken, die ebenfalls die Stromtragfähigkeit verbessern, vgl. L.R. Motowidlo et al., Supercond. Sci. Technol. 31, 014002.

Die interne Oxidation wird beispielsweise auch beschrieben in der WO 2015/175064 A2, oder in X. Xu et al., Adv. Mater. 2015, 27, Seiten 1346-1350, oder in X. Xu et al., Appl. Phys. Lett. 104, 082602 (2014), oder in X. Xu, Dissertation "Prospects for Improving the Critical Current Density of Superconducting Nb3Sn Strands via Optimization of Nb3Sn Fraction, Stochiometry, and Grain Size", The Ohio State University 2016, chapter 5, oder in X. XU et al. FERMILAB-CONF-16-342-TD (2016).

Beispielsweise in der EP 2 779 258 B1 ist der typische Aufbau eines herkömmlichen Monofilaments für einen Powder-in-tube Halbzeugdraht beschrieben. Ein solches Monofilament umfasst ein dünnwandiges inneres Rohr, meist aus Kupfer, in welchem ein Sn-haltiges Pulver (Pulverkern) angeordnet ist. Dieses innere Rohr ist wiederum in einem dickwandigen äußeren Rohr angeordnet, meist aus Niob (Reaktions-Rohr). Beim Reaktionsglühen diffundiert Sn aus dem Pulverkern zum Reaktionsrohr und bildet dort die Nb₃Sn-Phase.

Das Dokument EP1993107 zeigt in den Abb. 1 und 2 einen supraleitenden Nb₃Sn Draht mit einem pulverisierten Sn Kern umgeben von zwei Cu-Zylindern (8, 9) und mehreren Nb Metallzylindern (5, 6, 7).

In der WO 2015/175064 A2 wird ein Monofilament für einen Powder-in-tube Halbzeugdraht für die interne Oxidation vorgeschlagen, bei dem in einem Rohr aus einer NbZr-Legierung direkt eine Mischung aus einem Sn-haltigen Pulver und einem Metalloxidpulver angeordnet ist. Sauerstoff aus dem Metalloxidpulver gelangt beim Reaktionsglühen in das Rohr aus der NbZr-Legierung und bildet ZrO₂-Ausscheidungen. Mit diesem Halbzeugdraht soll eine Kornfeinung auf beispielsweise 5-30 nm durchschnittliche Korngröße für das gebildete Nb₃Sn erreichbar sein.

Bei X. Xu et al., Adv. Mater. 2015, 27, Seiten 1346-1350 wird in Bezug auf einen von Zeitlin et al. für eine interne Oxidation vorgeschlagenen Leiter umfassend eine Vielzahl von ringartig angeordneten NbZr-Filamenten in einer inneren und äußeren Kupfermatrix und mit einem Pulverkern enthaltend Sn und SnO₂, der keine Kornfeinung zeigte, ausgeführt, dass eine Kupferschicht zwischen dem Pulverkern und den ZrO₂-Filamenten den Sauerstofftransport blockiert habe, vgl. S. 2, rechte Spalte, letzter Absatz. In der Dissertation von Xu, aaO, S. 121, letzter Satz, wird die gleiche Vermutung geäußert.

### Aufgabe der Erfindung

Es ist Aufgabe der vorliegenden Erfindung, eine Monofilament für einen Powder-in-tube basierten Nb3Sn-haltigen Supraleiterdraht vorzuschlagen, mit dem eine weiter verbesserte Stromtragfähigkeit erreicht werden kann.

### Beschreibung der Erfindung

Diese Aufgabe wird erfindungsgemäß gelöst durch ein Monofilament der eingangs genannten Art, das dadurch gekennzeichnet ist,
dass der Pulverkern in einem Moderations-Rohr angeordnet ist,
und dass das Moderations-Rohr innerhalb des Reaktions-Rohrs angeordnet ist.

Das erfindungsgemäße Monofilament ist dafür ausgebildet, beim einem Reaktionsglühen, das typischerweise in einem Temperaturbereich zwischen 400°C und 800°C stattfindet, im Gefüge der Nb₃Sn-Phase Ausscheidungen XPk zu erzeugen. Die Legierungskomponente X wird über das Reaktions-Rohr zur Verfügung gestellt, und die (wenigstens eine) Partnerkomponente Pk wird über (wenigstens eine) im Monofilament eingerichtete Quelle zur Verfügung gestellt. Im Rahmen der Wärmebehandlung des Reaktionsglühens diffundiert die Partnerkomponente Pk zum Reaktions-Rohr und bildet dort die Ausscheidungen XPk.

Die Ausscheidungen im Gefüge der Nb₃Sn-Phase können auf zwei Weisen zu einer verbesserten Stromtragfähigkeit beitragen: Ausscheidungen, die vor der Entstehung der Nb₃Sn-Phase gebildet werden, erzeugen Nukleationskeime und hemmen das Kornwachstum und sorgen so für ein feineres Gefüge. Da Korngrenzen als Pinningzentren wirken, erhöht die Feinung des Gefüges die Stromtragfähigkeit. Ausscheidungen, die nach Entstehung der Nb₃Sn-Phase gebildet werden, können als künstliche Pinningzentren (artificial pinning centers, APCs) dienen, die ebenfalls die Stromtragfähigkeit erhöhen können.

Mit dem Moderations-Rohr kann die Diffusion von Sn vom Pulverkern zum Reaktions-Rohr gesteuert werden. Sofern der Pulverkern gleichzeitig eine Quelle für die (wenigstens eine) Partnerkomponente Pk darstellt, kann über das Moderations-Rohr auch auf die Diffusion der Partnerkomponente Pk zum Reaktions-Rohr Einfluss genommen werden; insbesondere kann die Konzentration von Partnerkomponente Pk (etwa Sauerstoff) vor/an der Reaktionsfront während der Bildung der verschiedenen intermetallischen Nb-Sn Phasen während der Wärmebehandlung eingestellt werden.

Dadurch wird es möglich, Ausscheidungen zeitlich gezielt entstehen zu lassen. Insbesondere kann durch die Dimensionierung und Lage des Moderations-Rohres und der wenigstens einen Quelle für die Partnerkomponente in einer entsprechenden Wärmebehandlung eingestellt werden, ob oder in wie weit die Bildung von Ausscheidungen vor oder nach der Nb₃Sn-Phasenbildung erfolgen soll. Über diese Balance zwischen Kornfeinung (durch Ausscheidungen/Oxidation vor der Nb₃Sn-Bildung) und punktförmigen Ausscheidungen (hauptsächlich durch Ausscheidungen/Oxidation nach der Nb₃Sn-Phasenbildung) kann der Abstand zwischen Pinningzentren im Leiter auf den Anwendungsfall des Leiters eingestellt werden. Erfolgt die Ausscheidungsbildung/Oxidation vor der Nb₃Sn Phasenbildung, entsteht ein feineres Nb₃Sn Gefüge. Erfolgt sie danach, bilden sich Ausscheidungen innerhalb des bereits bestehenden Nb₃Sn-Gefüges. Durch die Einstellung dieser Prozesse kann eine besonders hohe kritische Stromdichte der Nb₃Sn-Phase in einem großen Magnetfeldbereich erhalten werden.

Während im Stand der Technik für die dortigen Monofilamente für Powder-in-tube Halbzeugdrähte vorgesehen ist, die Pulvermischung des Pulverkerns direkt im Reaktions-Rohr anzuordnen, ist es nach den Einsichten der Erfinder besser, ein Moderations-Rohr vorzusehen, in welchem der Pulverkern enthalten ist, um das Diffusionsverhalten von Sn und ggf. auch von Partnerkomponente Pk aus dem Pulverkern in das Reaktions-Rohr besser kontrollieren zu können. Ein direkter Kontakt des Pulverkerns zum Reaktionsrohr ist nicht erforderlich, und ist zur Erlangung einer verbesserten Stromtragfähigkeit des fertigen Nb₃Sn-Supraleiterdrahts nach den Erkenntnissen der Erfinder sogar nachteilig. Eine prohibitive Blockade einer etwaigen Partnerkomponente, insbesondere Sauerstoff, aus dem Pulverkern tritt nach den Erkenntnissen der Erfinder jedenfalls bei geeigneter Dimensionierung des Monofilaments nicht ein.

Die Legierungskomponente X ist typischerweise ein Metall, und die Partnerkomponente Pk ist typischerweise Sauerstoff, und die Ausscheidungen XPk bestehen typischerweise aus einem Metalloxid; es ist aber auch möglich, mit anderen Partnerkomponenten nicht-oxidische Ausscheidungen zu erhalten, und insbesondere nach dem Reaktionsglühen einen Supraleiterdraht ohne oxidische Ausscheidungen zu erhalten.

Im Rahmen der Erfindung ist es möglich, im Reaktions-Rohr eine oder auch mehrere Arten von Legierungskomponenten X und in der oder den Quellen eine oder auch mehrere Arten von Partnerkomponenten Pk vorzuhalten, mit denen eine oder auch mehrere Arten von Ausscheidungen XPk gebildet werden können. In einfachen Ausführungsformen werden nur eine Art von Legierungskomponente X und eine Art von Partnerkomponente Pk eingesetzt, die in einer Art von Ausscheidung XPk resultieren. Falls mehrere Arten von Partnerkomponenten Pk eingesetzt werden, können diese in einer gemeinsamen Quelle vorgehalten werden, oder auch auf verschiedene Quellen verteilt sein, insbesondere so dass jede Quelle nur eine Art von Partnerkomponente Pk vorhält. Die Abkürzung XPk steht für beliebige stöchiometrischen Verhältnisse von X und Pk in der Ausscheidung.

Eine Quelle wird durch eine oder mehrere Quellstrukturen ausgebildet, die bei einer einheitlichen radialen Position (entsprechend einem Radiusintervall, innerhalb dessen sich alle Quellstrukturen gleichermaßen erstrecken) angeordnet sind. Eine Quelle kann ringartig oder ringförmig ausgebildet sein (das Zentrum des Monofilaments nicht einschließend, also radial nach innen und außen begrenzt sein), oder auch zentral ausgebildet sein (das Zentrum des Monofilaments einschließend, also nur nach radial außen begrenzt sein). Besteht die Quelle aus nur einer Quellstruktur, ist diese typischerweise vollständig umlaufend (über 360°) ausgebildet. Besteht die Quelle aus mehreren Quellstrukturen, sind diese typischerweise ringartig und/oder in Umfangsrichtung gleichmäßig verteilt angeordnet. Unterschiedliche Quellen weisen eine unterschiedliche radiale Position (mit nicht-überlappenden Radiusintervallen) auf. Typische Quellen werden ausgebildet durch ein Pulver (bzw. einen Pulveranteil) im Pulverkern (der dann gleichzeitig Quellstruktur ist), oder durch ein Pulver (bzw. einen Pulveranteil) in einer ringförmigen umlaufenden Pulverschicht (als Quellstruktur) im Monofilament, oder durch ein Pulver (bzw. einem Pulveranteil) einer Füllung von ringartig angeordneten Quellröhrchen (als mehrere Quellstrukturen), oder durch ein Pulver (bzw. einen Pulveranteil) einer Füllung von ringartig angeordneten Quelltaschen (als mehrere Quellstrukturen) an oder in einer anderen Struktur des Monofilaments, oder durch eine umlaufende Beschichtung (als Quellstruktur) auf einer anderen Struktur des Monofilaments.

Das Moderations-Rohr ist typischerweise durchgehend mit einem einheitlichen Gefüge und bevorzugt mit einer einheitlichen Wandstärke ausgebildet; es kann aber auch aus mehreren geschachtelten Teilrohren unterschiedlicher Zusammensetzung ausgebildet sein. Die Wandstärke WM des Moderations-Rohrs ist meist relativ klein im Verhältnis zum Durchmesser DP des Pulverkerns, meist mit WM ≤0,2^{∗}DP.

Das Moderations-Rohr hat typischerweise eine andere chemische Zusammensetzung als das Reaktions-Rohr. Falls das Moderations-Rohr direkt an das Reaktions-Rohr angrenzt, enthält das Moderations-Rohr typischerweise kein oder deutlich weniger Niob als das Reaktions-Rohr, z.B. 10,0 Gew% Nb oder weniger, oder auch 1,0 Gew% Nb oder weniger. Falls das Moderations-Rohr nicht an das Reaktions-Rohr angrenzt, kann das Moderations-Rohr ohne Weiteres auch mehr Nb enthalten oder aus Nb bestehen. Das Moderations-Rohr enthält aber meist Cu, beispielsweise zu 50 Gew% oder mehr.

Das Reaktions-Rohr kann neben Nb und der wenigstens einer weiteren Legierungskomponente X auch andere Legierungskomponenten enthalten, die keine Ausscheidungen bilden, aber für die Bildung und/oder die Stromtragfähigkeit der Nb₃Sn-Phase förderlich sind, wie beispielsweise Tantal oder Titan. Das Reaktions-Rohr ist durchgehend ausgebildet und weist grundsätzlich ein einheitliches Gefüge, bevorzugt mit einer einheitlichen Wandstärke auf.

Der Pulverkern kann Ag, Cu, Sn, C, MoS₂, Stearate und/oder α-BN enthalten, insbesondere um die Verarbeitungseigenschaften beim Herstellen und/oder Umformen des Monofilaments zu verbessern, etwa beim Ziehen. Cu kann zudem als Katalysator für die Entstehung der Nb₃Sn-Phase dienen. Die im Pulverkern enthaltenen Elemente und Verbindungen dienen im Weiteren der Einstellung der Sn-Abgabe und ggf. der Pk-Abgabe während der Wärmebehandlung.

Das Monofilament umfasst typischerweise ein Hüllrohr (auch bezeichnet als Matrix), das meist aus Cu oder einer Cu-Legierung gefertigt ist, und das das Monofilament außen umschließt. Meist ist auch eine Diffusionsbarriere innenseitig am Hüllrohr ausgebildet, um eine Eindiffusion von Sn oder Pk in das Cu zu verhindern, und so das Restwiderstandsverhältnis (RRR) und die thermische Leitfähigkeit der Matrix nicht zu reduzieren.

Typischerweise werden eine Vielzahl von Monofilamenten gebündelt und umgeformt, ggf. auch mehrstufig, um einen Halbzeugdraht zu erhalten. Der Halbzeugdraht wird in die gewünschte Form gewickelt (etwa eine Spule) und dem Reaktionsglühen unterzogen, wobei die Nb₃Sn-Phase und damit der Supraleiterdraht entsteht. Die Wärmebehandlung wird typischerweise so gewählt, dass die entstehenden Ausscheidungen eine möglichst hohe Stromdichte im Anwendungsfall liefern. Insbesondere ist hierbei wichtig, ob die Reaktion von X mit Pk lokal vor und/oder nach der Nb₃Sn Phasenbildung stattfindet.

### Bevorzugte Ausführungsformen

### Allgemeine Ausführungsformen des Monofilaments

Bei einer bevorzugten Ausführungsform des erfindungsgemäßen Monofilaments sind im Monofilament wenigstens zwei an unterschiedlichen radialen Positionen angeordnete Quellen Q für die wenigstens eine Partnerkomponente Pk enthalten. Dadurch, dass die Quellen räumlich (insbesondere radial) unterschiedlich angeordnet werden, kann die während des Reaktionsglühens benötigte Diffusionszeit der Partnerkomponente Pk von der jeweiligen Quelle zum Reaktions-Rohr unterschiedlich eingestellt werden, etwa über die Länge des jeweiligen Diffusionspfades und/oder über die Geschwindigkeit der Diffusion, insbesondere durch etwaige dazwischenliegenden Strukturen des Monofilaments. Durch die räumliche Trennung der Quellen kann somit während der Wärmebehandlung eine zeitliche Differenz der Ankunft der jeweiligen (meist für beide Quellen gleichen) Partnerkomponente Pk aus den wenigstens zwei Quellen im Reaktions-Rohr erreicht werden, insbesondere um einen Teil der im Monofilament bereitgestellten Stoffmenge an Partnerkomponente Pk vor der Bildung des Nb₃Sn und einen Teil nach der Bildung des Nb₃Sn im Bereich des Reaktions-Rohrs zur Verfügung zu stellen bzw. zu Ausscheidungen XPk reagieren zu lassen. Dadurch kann gezielt sowohl eine Kornfeinung des Nb₃Sn bewirkt bzw. eingestellt werden, als auch gezielt die Bildung von Pinningzentren im bestehenden Nb₃Sn erreicht werden. Hierdurch können besonders hohe Stromtragfähigkeiten eines finalen Supraleiterdrahtes erreicht werden.

Bevorzugt ist auch eine Ausführungsform, bei der das Moderations-Rohr ganz oder teilweise aus Cu oder einer Cu-Legierung oder Ag oder einer Ag-Legierung oder Sn oder einer Sn-Legierung oder Nb oder einer Nb-Legierung gefertigt ist. Mit diesen Materialien kann ein gutes Umformverhalten des Monofilaments erreicht werden, insbesondere für weitere Querschnittsreduktionen und Bündelungsschritte. Man beachte, dass das Moderations-Rohr auch aus mehreren geschachtelten Teilrohren bestehen kann, die aus unterschiedlichen Materialien gefertigt sind, insbesondere aus den oben angegebenen Metallen oder Legierungen.

Vorteilhaft ist weiterhin eine Ausführungsform, bei der die wenigstens eine Quelle Q für die wenigstens eine Partnerkomponente Pk ein Pulver umfasst. Bevorzugt basieren alle Quellen auf Pulver. Pulver gestatten bei Umformprozessen eine Bewegung der Pulverpartikel relativ zu benachbarten Strukturen und anderen Pulverpartikeln, wodurch Materialfehler im Monofilament bzw. Halbzeugdraht minimiert werden können, insbesondere wenn die Pulverpartikel (beispielsweise Metalloxidpulver) selbst nicht plastisch verformbar sind.

### Ausführungsformen mit Quelle im Pulverkern

Bevorzugt ist eine Ausführungsform, bei der die wenigstens eine Quelle Q für die wenigstens eine Partnerkomponente *Pk* ein im Pulverkern enthaltenes Pulver umfasst. Die Einrichtung einer Quelle für die wenigstens eine Partnerkomponente im Pulverkern ist besonders einfach möglich; ein entsprechendes Pk-haltiges Pulver kann dem Pulver, das als Sn-Quelle dient, beigemischt werden. Zudem kann auf das Diffusionsverhalten von Partnerkomponente Pk aus dieser Quelle auch über das Moderations-Rohr Einfluss genommen werden.

Eine vorteilhafte Weiterbildung dieser Ausführungsform sieht vor, dass die Quelle Q, die ein im Pulverkern enthaltenes Pulver umfasst, als Partnerkomponente Pk Sauerstoff enthält, und das Moderations-Rohr aus Cu oder einer Cu-Legierung gefertigt ist. Überraschender Weise hat sich gezeigt, dass eine ausreichende Diffusion von Sauerstoff vom Pulverkern aus durch das Cu-haltige Moderations-Rohr erhalten werden kann, um für eine gute Stromtragfähigkeit bzw. Kornfeinung rechtzeitig und ausreichend viele Ausscheidungen im Reaktions-Rohr zu bilden. Insbesondere kann über die Dicke (Wandstärke) des Moderations-Rohrs der Diffusionsweg des Sn und der Partnerkomponente Pk eingestellt werden, wobei sich die Diffusionsgeschwindigkeit von Sn und Pk im Moderations-Rohr grundsätzlich unterscheiden (ggf. unterstützt durch Zusätze im Pulverkern) und dadurch der Zeitpunkt und Ort der Ausscheidung von XPk eingestellt werden kann.

Besonders bevorzugt ist eine Weiterbildung, bei der die Wandstärke WM des Moderations-Rohrs gewählt ist mit
WM ≤ 0,075^{∗}DP und/oder WM ≤ 0,2^{∗}WR
mit DP: Durchmesser des Pulverkerns und WR: Wandstärke des Reaktions-Rohrs. Bei diesen Wandstärken des Moderationsrohrs hat sich eine ausreichend gute Diffusion der Partnerkomponente Pk durch das Moderations-Rohr ergeben, einschließlich des Falls, dass die Partnerkomponente Pk im Pulverkern Sauerstoff ist; insbesondere hat sich auch keine hinderliche Nioboxid-Sperrschicht für O gebildet. Falls die Wandstärke über den Umfang schwankt, kann als Wandstärke für obige Formeln jeweils die größte auftretende Wandstärke angenommen werden. Allgemein vorteilhaft hat sich auch ein Stoffmengenverhältnis Pk/X von 0,5-30 für das Monofilament erwiesen; ebenso allgemein vorteilhaft ist ein Anteil von 1-30 Atom% von Pk im Pulverkern. Die Wandstärke des Moderations-Rohrs kann so gewählt werden, dass die Erzeugung der Ausscheidungen und damit die in-Feld-Eigenschaften des Leiters gesteigert und ggf. auch auf den Anwendungsfall angepasst werden. Bevorzugt gilt auch WM ≥ 0,02^{∗}DP und/oder WM ≥ 0,05^{∗}WR.

Bevorzugt ist weiterhin eine Weiterbildung, bei der der Pulverkern Cu, Ag und/oder Sn enthält, insbesondere elementares Cu, Ag und/oder Sn enthält. Dadurch können die Verarbeitungseigenschaften des Monofilaments verbessert und gegebenenfalls die Diffusionseigenschaften der Partnerkomponente Pk im Pulverkern, insbesondere wenn die Partnerkomponente Sauerstoff ist, eingestellt werden.

### Ausführungsformen mit einer ringartigen Quelle

Bei einer bevorzugten Ausführungsform umfasst die wenigstens eine Quelle Q für die wenigstens eine Partnerkomponente Pk eine ringartige Quelle, wobei das Moderations-Rohr radial innerhalb der ringartigen Quelle angeordnet ist. Mit einer ringartigen Quelle außerhalb des Moderations-Rohrs kann eine Partnerkomponente Pk in das Monofilament eingebracht werden, ohne dass die Partnerkomponente Pk das Moderations-Rohr passieren muss. Art und Wandstärke des Moderationsrohrs kann dann allein gemäß dem gewünschten Diffusionsverhalten des Sn aus dem Pulverkern eingestellt werden. Dies macht die Kontrolle der Diffusionsprozesse einfacher. Wenn die Partnerkomponente Pk außerhalb des Pulverkerns angeordnet ist, kann insbesondere mit einem vergleichsweise dickwandigen und/oder für Sn nur wenig durchlässigen Moderations-Rohr die Nb-Sn Phasenbildung aus dem Pulverkern zeitlich stark von der Ausscheidungsbildung (etwa Oxidation) entkoppelt werden, um eine größere Menge von Ausscheidungen zu bilden, bevor die Nb₃Sn Phasenbildung beginnt. Insbesondere kann eine Einbringung von Pk in das Reaktions-Rohr (etwa eine Sauerstoffabgabe) gegebenenfalls direkt am Reaktions-Rohr erfolgen. Die Einbringung von Pk kann je nach Menge an eingesetztem Pk durch Additive wie z.B. Cu-Pulver eingestellt werden. Über die Ringform ist ein im Wesentlichen gleichmäßiger Eintrag der Partnerkomponente über den Umfang in das Monofilament möglich. Man beachte, dass das Monofilament auch mehrere ringartige Quellen für die wenigstens eine Partnerkomponente Pk umfassen kann, in denen jeweils das Moderations-Rohr angeordnet ist. Insbesondere können eine ringartige Quelle außerhalb des Reaktions-Rohrs und eine ringartige Quelle innerhalb des Reaktions-Rohrs vorgesehen sein, oder auch zwei ringartige Quellen außerhalb des Reaktions-Rohrs. Eine ringartige Quelle kann aus einer Quellstruktur bestehen (etwa als umlaufende Beschichtung oder als umlaufende Pulverschicht), oder auch aus mehreren auf einem Ring angeordneten diskreten Quellstrukturen gebildet werden (etwa Pulverfüllungen in Quelltaschen oder Quellröhrchen).

Bevorzugt ist eine Weiterbildung dieser Ausführungsform, bei der die ringartige Quelle ein Pulver in einer umlaufende Pulverschicht umfasst. Mit einem Pulver kann ein gutes Umformverhalten erhalten werden, auch wenn das Pulver nicht-metallische und/oder plastisch nicht verformbare Pulverpartikel enthält. Die Pulverschicht ist vergleichsweise leicht einzubringen, etwa in einen Spalt zwischen zwei rohrartige Strukturen einzufüllen.

Bei einer alternativen Weiterbildung umfasst die ringartige Quelle ein Pulver in einer Pulverfüllung von ringartig angeordneten Quellröhrchen oder Quelltaschen, wobei die Quelltaschen in einer zu der ringartigen Quelle benachbarten Struktur des Monofilaments ausgebildet sind. Mittels der Quellröhrchen (die einen runden oder anderen Querschnitt haben können) kann die Handhabung des Pulvers für die Quelle bei der Herstellung des Monofilaments vereinfacht werden. Insbesondere kann im Quellröhrchen in der Regel vergleichsweise einfach eine gleichmäßige und hohe Pulverdichte erhalten werden. Die Quellröhrchen können insbesondere aus Kupfer oder Nb oder einer X-haltigen Nb-Legierung (insbesondere der X-haltigen Nb-Legierung des Reaktions-Rohrs) gefertigt sein. Die Quellröhrchen werden typischerweise in einen Spalt zwischen zwei andere Strukturen des Monofilaments eingelegt, etwa zwischen das Moderations-Rohr und das Reaktions-Rohr, oder zwischen das Reaktions-Rohr und ein Zusatz-Reaktionsrohr. Quelltaschen können als radiale Rücknehmungen an der Innenseite oder Außenseite der benachbarten Struktur, oder auch als Hohlräume in der benachbarten Struktur ausgebildet sein; in den Quelltaschen ist es meist leichter, eine gleichmäßige Pulverdichte zu erhalten als in einer umlaufenden Pulverschicht. Bei einer Quelle umfassend mehrere ringartig angeordnete Quellstrukturen können in Umfangsrichtung zwischen den Quellstrukturen (radial) durchgängige Strukturbereiche verbleiben, die für eine bessere Verarbeitbarkeit im Vergleich zu einer umlaufenden (in Umfangsrichtung durchgängigen oder segmentierten) Quelle sorgen.

Bevorzugt ist dabei, wenn die Pulverschicht oder die Pulverfüllung ein metallisches Pulver enthält, insbesondere wobei das metallische Pulver elementares Cu oder eine Cu-Legierung oder Ag oder eine Ag-Legierung enthält. Durch das metallische Pulver können die Verarbeitungseigenschaften verbessert werden sowie gegebenenfalls die Pk-Abgabe bzw. Pk-Aufnahme verbessert bzw. für den Anwendungsfall eingestellt werden. Zur Einstellung der Diffusionseigenschaften der Partnerkomponente eignen sich insbesondere Cu, Ag oder Sn.

Bei einer weiteren Weiterbildung umfasst die ringartige Quelle eine umlaufende Beschichtung einer zur ringartigen Quelle benachbarten Struktur des Monofilaments, insbesondere wobei die benachbarte Struktur das Reaktions-Rohr oder das Moderations-Rohr ist. Eine Beschichtung ist vergleichsweise einfach aufzubringen, etwa an einer Struktur, bevor sie in das Monofilament eingesetzt wird. Eine Beschichtung kann beispielsweise mittels Sprühbeschichtung erfolgen.

### Ausführungsformen mit einer äußeren ringartigen Quelle

Bevorzugt ist weiterhin eine Weiterbildung, bei der das Reaktions-Rohr radial innerhalb der ringartigen Quelle angeordnet ist, insbesondere wobei die ringartige Quelle das Reaktions-Rohr außen direkt umschließt. Aus der ringartigen Quelle außerhalb des Reaktions-Rohrs kann unabhängig von der Diffusion des Sn aus dem Pulverkern in das Reaktions-Rohr eine Eindiffusion der Partnerkomponente in das Reaktions-Rohr erfolgen. Dadurch können beide Diffusionsprozesse leicht aufeinander abgestimmt werden. Bei einem direkten Umschließen des Reaktions-Rohrs durch die ringartige Quelle kann ein besonders schneller Eintrag von Partnerkomponente Pk in das Reaktions-Rohr erfolgen, etwa für eine gute Kornfeinung für Ausscheidungen vor der Bildung der Nb₃Sn-Phase. Alternativ zu einem direkten Umschließen kann auch ein Hilfs-Moderationsrohr vorgesehen sein, das zwischen dem Reaktions-Rohr und der ringartigen Quelle angeordnet ist; dadurch kann das Einbringen der Partnerkomponente zeitlich während des Reaktionsglühens besser kontrolliert, und insbesondere verzögert, werden.

Bevorzugt ist dabei vorgesehen, dass das Monofilament ein Zusatz-Reaktionsrohr umfasst, wobei das Zusatz-Reaktionsrohr Nb enthält,
insbesondere wobei das Zusatz-Reaktionsrohr weiterhin auch die mindestens eine weitere Legierungskomponente X enthält,
und dass die ringartige Quelle radial innerhalb des Zusatz-Reaktionsrohrs angeordnet ist,
insbesondere wobei das Zusatz-Reaktions-Rohr die ringartige Quelle außen direkt umschließt. Wenn die ringartige Quelle zwischen Reaktions-Rohr und Zusatz-Reaktionsrohr angeordnet ist, kann die Partnerkomponente radial nach außen und innen weitergegeben werden, für eine besonders schnelle Durchdringung dieser beiden Rohre.

### Ausführungsformen mit einer inneren ringartigen Quelle

Vorteilhaft ist auch eine Weiterbildung, bei der die ringartige Quelle radial außerhalb des Moderations-Rohrs und radial innerhalb des Reaktions-Rohrs angeordnet ist. Bei dieser Anordnung erreichen Partnerkomponente und Sn das Reaktions-Rohr von der gleichen Seite, wodurch in der Regel ausgewogene Konzentrationsverhältnisse von Sn und Pk sowie Nb und X an der Reaktionsfront der Nb₃Sn-Bildung erreicht werden können. Insbesondere ist es nicht nötig, dass die Partnerkomponente das Reaktions-Rohr vollständig mittels Diffusion durchquert, wie es bei einer außenliegenden ringartigen Quelle der Fall wäre. Hierdurch können besonders hohe Stromtragfähigkeiten erreicht werden. Wenn lediglich die Sn-Diffusion durch das Moderations-Rohr erfolgt, kann dessen Material flexibler gewählt werden. Dies erlaubt die Verwendung von Materialien mit besonders niedriger Sn-Durchlässigkeit. Dadurch können die Sn-Diffusion und die Pk-Diffusion stärker entkoppelt werden als bei gemischten Pulverkernen.

Vorteilhaft ist hierbei vorgesehen, dass das Monofilament weiterhin ein Zusatz-Moderationsrohr umfasst, und dass die ringartige Quelle radial innerhalb des Zusatz-Moderationsrohrs angeordnet ist, und das Zusatz-Moderationsrohr radial innerhalb des Reaktions-Rohrs angeordnet ist,
insbesondere wobei das Zusatz-Moderationsrohr die ringartige Quelle außen direkt umschließt. Mit dem Zusatz-Moderationsrohr kann die Eindiffusion aus der ringartigen Quelle in das Reaktions-Rohr kontrolliert werden. Typische Materialien für das Zusatz-Moderationsrohr entsprechend den Materialien für das Moderationsrohr.

### Ausführungsformen zu den chemischen Systemen

Bei einer bevorzugten Ausführungsform ist vorgesehen, dass die wenigstens eine Quelle eine chemische Verbindung enthaltend eine Partnerkomponente Pk der wenigstens einen Partnerkomponente Pk umfasst, wobei die chemische Verbindung unter Wärmeeinwirkung bei einer ersten Temperatur T1 in diese Partnerkomponente Pk und eine erste Restverbindung zerfällt, wobei die erste Restverbindung auch noch diese Partnerkomponente Pk enthält, jedoch mit einem geringeren stöchiometrischen Anteil als die chemische Verbindung, und unter weiterer Wärmeeinwirkung bei einer zweiten Temperatur T2, mit T2>T1, die erste Restverbindung in diese Partnerkomponente Pk und eine zweite Restverbindung zerfällt. Dadurch ist es möglich, die Partnerkomponente Pk während des Reaktionsglühens, bei Anwendung eines geeigneten Temperaturprogramms (etwa mit einem ersten Temperaturplateau bei oder etwas über T1 und einem zweiten Temperaturplateau bei oder etwas über T2, oder auch mit einem langsamen Temperaturanstieg bis T1 und darüber hinaus bis T2 oder etwas darüber) zu unterschiedlichen Zeitpunkten freizusetzen und dadurch gezielt einen Teil der Partnerkomponente vor der Bildung von Nb₃Sn, und einen Teil nach oder während der Bildung von Nb₃Sn zur Verfügung zu stellen. Eine zweistufig Sauerstoff freisetzende chemische Verbindung ist beispielsweise Kaliumpermanganat. Alternativ kann die Quelle auch eine chemische Verbindung enthalten, die in die Partnerkomponente Pk und eine Restverbindung zerfällt, die keine Partnerkomponente Pk mehr enthält.

Bei einer anderen vorteilhaften Ausführungsform ist vorgesehen, dass die wenigstens eine Quelle Q wenigstens zwei verschiedene Partnerkomponenten Pk enthält, die beim Reaktionsglühen mit der wenigstens einen weiteren Legierungskomponente X unterschiedliche Arten von Ausscheidungen XPk bilden können,
insbesondere wobei das Reaktions-Rohr auch wenigstens zwei verschiedene weitere Legierungskomponenten X enthält, und die verschiedenen Partnerkomponenten Pk jeweils mit einer anderen der verschiedenen weiteren Legierungskomponenten X jeweils die unterschiedlichen Ausscheidungen XPk bilden. In der Regel werden die beiden verschiedenen Partnerkomponenten zu unterschiedlichen Zeitpunkten während der Wärmebehandlung beim Reaktionsglühen freigesetzt und/oder die verschiedenen Partnerkomponenten weisen eine unterschiedliche Diffusionsgeschwindigkeit auf. Dadurch ist es möglich, Ausscheidungen gezielt sowohl vor als auch nach der Bildung der Nb₃Sn-Phase zu bilden, um die Stromtragfähigkeit durch Kornfeinung und Bildung von Pinningzentren zu verbessern.

Vorteilhaft ist auch eine Ausführungsform, bei der die wenigstens eine Quelle Q eine erste chemische Verbindung und eine zweite chemische Verbindung jeweils enthaltend die gleiche Partnerkomponente Pk enthält, wobei unter Wärmebehandlung die erste chemische Verbindung die Partnerkomponente Pk bei einer niedrigeren Temperatur freisetzt als die zweite chemische Verbindung. Die erste chemische Verbindung setzt Pk bei der Temperatur T1 frei, und die zweite chemische Verbindung setzt Pk bei T2 frei, mit T1<T2. Dadurch ist es wiederum möglich, die Partnerkomponente Pk während des Reaktionsglühens, bei Anwendung eines geeigneten Temperaturprogramms (etwa mit einem ersten Temperaturplateau bei oder etwas über T1 und einem zweiten Temperaturplateau bei oder etwas über T2, oder auch mit einem langsamen Temperaturanstieg von T1 bis T2 oder etwas darüber) zu unterschiedlichen Zeitpunkten freizusetzen und dadurch gezielt einen Teil der Partnerkomponente vor der Bildung von Nb₃Sn, und einen Teil nach oder während der Bildung von Nb₃Sn zur Verfügung zu stellen.

Besonders bevorzugt ist eine Ausführungsform, bei der die wenigstens eine Partnerkomponente Pk Sauerstoff umfasst, und die wenigstens eine Legierungskomponente X ein Metall umfasst, das unedler als Nb ist. Dieses Materialsystem ist besonders einfach und kostengünstig einzurichten.

Bei einer Weiterbildung dieser Ausführungsform umfasst die Quelle Q für die wenigstens eine Partnerkomponente Pk ein Pulver enthaltend ein Metalloxid, insbesondere wobei das Metalloxid SnO, SnO₂, CuO, Cu₂O, AgO, Ag₂O, Ag₂O₃, Na₂O₂, CaO₂, ZnO₂, MgO₂, NbO₂ oder Nb₂O₅ ist. Diese Materialsysteme zeigen eine gute Verbesserung der supraleitenden Stromtragfähigkeit, und sind einfach einzusetzen und kostengünstig. Das Metall der Legierungskomponente X wird unedler gewählt als das Metall des Metalloxids der Partnerkomponente Pk. Durch die Pulverform ist das Metalloxid im Monofilament leichter umzuformen.

Bevorzugt ist auch eine Weiterbildung, bei der wenigstens eine Legierungskomponente X eines oder mehrere der Elemente Mg, AI, V, Zr, Ti, Gd oder Hf umfasst. Diese Legierungskomponenten sind einfach zu handhaben, und bilden effektive Ausscheidungen zur Verbesserung der Stromtragfähigkeit des Supraleiterdrahts.

Bei einer vorteilhaften Ausführungsform ist vorgesehen, dass die Ausscheidungen XPk nicht-oxidische Ausscheidungen umfassen, insbesondere ausschließlich nicht-oxidische Ausscheidungen sind. Für die Ausbildung von nicht-oxidischen Ausscheidungen XPk wird die Partnerkomponente nicht als Sauerstoff gewählt; wenn ausschließlich nicht-oxidische Ausscheidungen gebildet werden sollen, darf keine der Partnerkomponenten Sauerstoff sein. Sauerstoff besitzt eine große Affinität zu einer Vielzahl von Stoffen, insbesondere den in Monofilament üblicherweise verbauten Metallen wie Nb, Sn und Cu. Dies kann zur Bildung von Oxidschichten an unerwünschten Stellen führen, die gewünschte Diffusionsprozesse blockieren. Durch die Verwendung von nicht-oxidischen Ausscheidungen, und entsprechend einem Verzicht auf Sauerstoff als Partnerkomponente, können diese Probleme größtenteils vermieden werden. Die Reaktionspartner von nicht-oxidischen Ausscheidungen können gezielt aufeinander abgestimmt werden, so dass diese bei der Wärmebehandlung im Wesentlichen nur untereinander reagieren, nicht aber mit anderen im Monofilament üblicherweise verbauten Metallen, und somit unerwünschte Nebenreaktionen, die erwünschte Diffusionsprozesse blockieren, minimiert oder ausgeschlossen werden können. Es ist auch möglich, für ein Monofilament mit zwei Partnerkomponenten Pk bzw. zwei verschiedenen Typen von Ausscheidungen XPk eine oxidische Ausscheidung und eine nicht-oxidische Ausscheidung vorzusehen.

Eine andere vorteilhafte Ausführungsform sieht vor, dass die Ausscheidungen nicht-metallische Ausscheidungen umfassen, insbesondere ausschließlich nicht-metallische Ausscheidungen sind. Nicht-metallische Ausscheidungen bilden markante Phasengrenzen zu umgebenden metallischen Nb3Sn-Matrix aus, was für ein Flusspinning meist günstig ist und besonders hohe Stromtragfähigkeiten erlaubt.

Bei einer bevorzugten Weiterbildung dieser Ausführungsform ist vorgesehen, dass die wenigstens eine Partnerkomponente *Pk* Schwefel umfasst, und die wenigstens eine Legierungskomponente X Zink umfasst. Schwefel kann beispielsweise elementar in ein Pulver eingebracht werden, oder auch als Sulfid eines edleren Metalls als Zink, etwa als Kupfersulfid, und ist vergleichsweise reaktionsfreudig. Zinksulfid kann vergleichsweise leicht Ausscheidungen ausbilden. Anstelle von Zink können auch andere unedle Metalle, insbesondere Alkalimetalle oder Erdalkalimetalle, als Legierungskomponente verwendet werden.

Bevorzugt ist auch eine Ausführungsform, bei der die wenigstens eine Partnerkomponente *Pk* Silizium, Kohlenstoff oder ein Halogen umfasst. Auch mit diesen Partnerkomponenten können Ausscheidungen als Alternative zu Sauerstoff als Partnerkomponente ausgebildet werden. Als Legierungskomponente X kann für diese Partnerkomponenten beispielsweise Ca (für Partnerkomponente Si, Si bevorzugt elementar in der Quelle vorliegend, für Ca₂Si-Ausscheidungen) oder Fe (für Partnerkomponente C, C bevorzugt graphitisch in der Quelle vorliegend, für Fe₃C-Ausscheidungen) oder Mg, AI, V, Zr, Ti, Ta, Gd oder Hf (für Partnerkomponente Halogen, das Halogen bevorzugt in der Quelle vorliegend als Halogenid, insbesondere als AgF oder SnF₂ oder Kupfertrifluoracetat, für die Bildung von halogenidischen Ausscheidungen) gewählt werden.

### Erfindungsgemäße Verfahren zur Herstellung eines Supraleiterdrahts

In den Rahmen der vorliegenden Erfindung fällt auch ein Verfahren zur Herstellung eines Supraleiterdrahts,
wobei mehrere erfindungsgemäße, oben beschriebene Monofilamente einstufig oder mehrstufig gebündelt und umgeformt werden, wodurch ein Halbzeugdraht erhalten wird,
und wobei der Halbzeugdraht in eine gewünschte Form gebracht, insbesonderewickelt, und einem Reaktionsglühen unterzogen wird, wobei aus der wenigstens einen Legierungskomponente X und der wenigstens einen Partnerkomponente *Pk* Ausscheidungen XPk gebildet werden und aus dem Nb der Reaktions-Rohre und dem Sn der Pulverkerne Nb₃Sn gebildet wird. Mit diesem Verfahren kann ein Supraleiterdraht mit besonders hoher Stromtragfähigkeit erhalten werden. Das Umformen kann beispielsweise als ein Ziehen ausgeführt werden. Das Reaktionsglühen findet typischerweise bei einer Temperatur zwischen 400 °C und 800 °C statt.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung schematisch dargestellt und wird anhand von Ausführungsbeispielen näher erläutert.
- Fig. 1: zeigt eine Ausführungsform eines erfindungsgemäßen Monofilaments, mit in den Pulverkern integrierter Quelle für die wenigstens eine Partnerkomponente;
- Fig. 2: zeigt eine Ausführungsform eines erfindungsgemäßen Monofilaments, mit einer um das Moderations-Rohr liegenden ringartigen Quelle und mit einem Zusatz-Moderationsrohr um die ringartigen Quelle;
- Fig. 3: zeigt eine Ausführungsform eines erfindungsgemäßen Monofilaments, mit einer um das Reaktions-Rohr liegenden ringringartigen Quelle und mit einer Diffusionsbarriere um die ringartigen Quelle;
- Fig. 4: zeigt eine Ausführungsform eines erfindungsgemäßen Monofilaments, mit einer in den Pulverkern integrierten ersten Quelle und einer um das Moderations-Rohr liegenden, ringartigen zweiten Quelle;
- Fig. 5: zeigt eine Ausführungsform eines erfindungsgemäßen Monofilaments, mit einer in den Pulverkern integrierten ersten Quelle und einer um das Reaktions-Rohr liegenden, ringartigen zweiten Quelle;
- Fig. 6: zeigt eine Ausführungsform eines erfindungsgemäßen Monofilaments, mit einer ringartigen ersten Quelle, die um das Reaktions-Rohr angeordnet ist, und einer ringartigen zweiten Quelle, die um ein ZusatzReaktionsrohr angeordnet ist, das die erste ringartige Quelle umgibt;
- Fig. 7: zeigt eine Ausführungsform eines erfindungsgemäßen Monofilaments, mit einer ringartigen Quelle, die mit rücksprungartigen Quelltaschen an der Innenseite des Reaktions-Rohrs ausgebildet ist;
- Fig. 8: zeigt eine Ausführungsform eines erfindungsgemäßen Monofilaments, mit einer ringartigen Quelle, die mit geschlossenen Quelltaschen im Inneren des Reaktions-Rohrs ausgebildet ist;
- Fig. 9: zeigt eine Ausführungsform eines erfindungsgemäßen Monofilaments, mit einer ringartigen Quelle, die mit Quellröhrchen ausgebildet ist, die zwischen dem Reaktions-Rohr und einem Zusatz-Reaktionsrohr angeordnet sind;
- Fig. 10: zeigt ein Halbzeug für einen Nb₃Sn-Supraleiterdraht, in welchem mehrere erfindungsgemäße Monofilamente gebündelt sind;
- Fig. 11: zeigt eine Ofenanordnung zur Durchführung eines Reaktionsglühens gemäß der Erfindung;
- Fig. 12: eine SEM-Aufnahme der Nb₃Sn-Phase eines erfindungsgemäß gefertigten Supraleiterdrahts mit sichtbaren Ausscheidungen auf einer Bruchfläche.

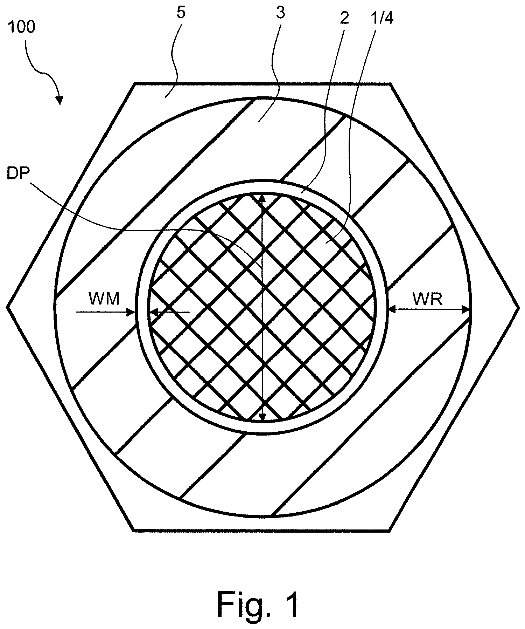

Die Figuren 1 bis 9 zeigen Ausführungsformen von erfindungsgemäßen Monofilamenten 100 im schematischen Querschnitt (also senkrecht zur Längsrichtung der Monofilamente 100), mit denen im Rahmen der Erfindung ein Nb₃Sn-haltiger Supraleiterdraht nach dem Power-in-tube-Ansatz gefertigt werden kann.

Alle Ausführungsformen umfassen einen zentralen Pulverkern 1, in welchem ein Sn-haltiges Pulver oder Pulvergemisch enthalten ist, weiterhin ein Moderations-Rohr 2, in welchem der Pulverkern 1 enthalten ist, und ein Reaktions-Rohr 3, das aus einer Legierung gefertigt ist, die Nb enthält (meist zu einem sehr großen Anteil, bevorzugt zu wenigstens 50 Gew% oder wenigstens 80 Gew%) und weiterhin wenigstens eine Legierungskomponente X enthält (meist mit einem geringen Anteil, zum Beispiel mit 0,3-3,0 Gew%). Aus dem Sn des Pulverkerns 1 und dem Nb des Reaktions-Rohrs 3 bildet sich beim Reaktionsglühen die Nb₃Sn-Phase. Nach außen hin wird das Monofilament 100 jeweils durch eine Matrix 5 (auch genannt Hüllrohr) begrenzt, die meist aus Cu oder einer Cu-Legierung gefertigt ist, die in den gezeigten Ausführungsformen jeweils eine hexagonale Außenkontur aufweist, um eine Bündelung zu erleichtern; alternativ kann die Matrix 5 auch mit einem runden Außenquerschnitt ausgebildet sein.

Zudem enthält das Monofilament 100 in jeder Ausführungsform wenigstens eine Quelle 4 für wenigstens eine Partnerkomponente Pk. Aus der Partnerkomponente Pk und der Legierungskomponente X entstehen beim Reaktionsglühen Ausscheidungen XPk, die (je nach Entstehungszeitpunkt) zu einer Kornfeinung der entstehenden Nb₃Sn-Phase oder zur Bildung von punktuellen Ausscheidungen in der vorhandenen Nb3Sn-Phase führen, die als Pinningzentren wirken, und dadurch die supraleitende Stromtragfähigkeit des fertigen Supraleiterdrahts verbessern.

Die verschiedenen Ausführungsformen von Monofilamenten 100 unterscheiden sich vor allem durch die Ausbildung der einen oder der mehreren Quellen 4, insbesondere deren Anzahl, geometrische Anordnung und Zusammensetzung.

Bei der Ausführungsform der **Fig. 1** dient der Pulverkern 1 gleichzeitig als die (einzige) Quelle 4 für die Partnerkomponente Pk (indiziert durch eine doppelte Schraffur des Pulverkerns 1). Der Pulverkern 1 wird hier gebildet durch eine Mischung aus Sn-Pulver und NbSn₂-Pulver (als Sn-Quelle für die Bildung von Nb₃Sn), weiterhin Cu-Pulver (als Katalysator für die Nb₃Sn-Bildung) und SnO₂-Pulver (als Quelle für die Partnerkomponente Pk, die hier Sauerstoff ist).

Das Moderations-Rohr 2, hier ausgebildet aus Cu, verfügt über eine vergleichsweise geringe Wandstärke WM im Vergleich zur Wandstärke WR des Reaktions-Rohrs 3 und dem Durchmesser DP des Pulverkerns 1, hier näherungsweise mit WM=0,15^{∗}WR und WM=0,055^{∗}DP. Dadurch kann eine ausreichende Diffusion des Sauerstoffs durch das Moderations-Rohr 2 erhalten werden. Man beachte, dass hier das Moderations-Rohr 2 sowohl die Diffusion des Sn als auch die Diffusion der Partnerkomponente Pk kontrolliert; zur Austarierung der Diffusion von Sn und Pk können im Pulverkern 1 geeignete weitere Zusätze, etwa von Ag-Pulver, vorgesehen sein.

Das Reaktions-Rohr 3 ist hier eine NbZr1-Legierung, also mit Zirkon als der Legierungskomponente X mit einem Anteil von 1 Gew%. Falls gewünscht, kann die Legierung des Reaktions-Rohrs 3 auch Ta oder andere Legierungszusätze enthalten, die für die Bildung der Nb₃Sn-Phase und/oder deren supraleitenden Eigenschaften förderlich sind. Beim Reaktionsglühen werden hier ZrO₂-Ausscheidungen im Nb₃Sn-Material gebildet.

Optional kann im Pulverkern 1 bzw. in der Quelle 4 neben SnO₂ auch eine weitere sauerstoffhaltige Verbindung, beispielsweise Gd₂O₃, vorgehalten werden. Dadurch wird eine zeitlich versetzte, zweimalige Freisetzung von Sauerstoff während der Wärmebehandlung erreicht.

Alternativ kann im Pulverkern 1 als Quelle 4 für Sauerstoff anstelle von SnO₂ auch eine zweistufig zerfallende, Pk-haltige chemische Verbindung bevorratet sein, etwa eine Permanganat-Verbindung wie KMnO₄. Das Permanganat kann zunächst einen Teil seines Sauerstoffs abspalten, wobei als erstes Reaktionsprodukt (erste Restverbindung) unter anderem MnO₂ entsteht. Dieses MnO₂ kann dann bei weiterer Wärmezufuhr weiteren Sauerstoff abspalten, wobei elementares Mn als zweites Reaktionsprodukt (zweite Restverbindung) entsteht. Auch dadurch wird eine zeitlich versetzte, zweimalige Sauerstofffreisetzung ermöglicht.

Durch eine zeitlich versetzte, zweimalige Freisetzung von Partnerkomponente Pk kann erreicht werden, dass Ausscheidungen sowohl vor einer Nb₃Sn-Bildung entstehen (für eine Kornfeinung der Nb₃Sn-Phase) als auch danach (für zusätzliche künstliche Pinningzentren).

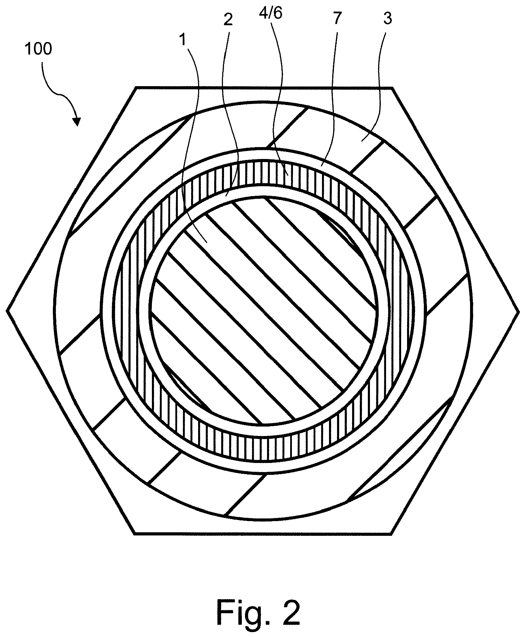

In der in **Fig.** 2 dargestellten Ausführungsform des Monofilaments 100 dient der Pulverkern 1 lediglich als Sn-Quelle, nicht aber als Quelle für eine Partnerkomponente (daher ist der Pulverkern nur einfach schraffiert dargestellt). Der Pulverkern 1 wird vom Moderations-Rohr 2 umschlossen, das hier lediglich die Diffusion von Sn kontrolliert, nicht aber von Partnerkomponente Pk. Das Moderations-Rohr 2 wird hier wiederum von der ringartigen (einzigen) Quelle 4 für Partnerkomponente Pk umschlossen, die hier als eine vollständig umlaufende Pulverschicht 6 enthaltend SnO₂-Pulver (zur Bereitstellung von Partnerkomponente Pk, nämlich Sauerstoff) und metallisches Cu-Pulver (Zur Verbesserung der Verformungseigenschaften) ausgebildet ist. Zwischen der Pulverschicht 6 und dem Reaktions-Rohr 3 ist hier noch ein Zusatz-Moderations-Rohr 7 angeordnet, mit dem die Eindiffusion der Partnerkomponente Pk und des Sn in das Reaktions-Rohr 3 gemeinsam kontrolliert wird.

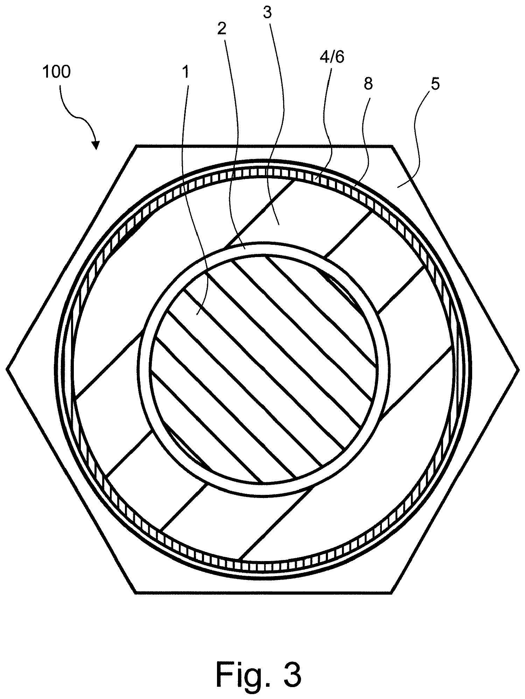

Bei der Ausführungsform des Monofilaments 100 von **Fig. 3** ist die ringartige (einzige) Quelle 4 für Partnerkomponente Pk wiederum als eine Pulverschicht 6 ausgebildet, jedoch radial außerhalb des Reaktions-Rohrs 3 angeordnet, wobei hier die Pulverschicht 6 das Reaktions-Rohr 3 direkt umschließt. Dadurch hat die Partnerkomponente Pk einen sehr schnellen Zugang zum Reaktions-Rohr 3. Das Sn aus dem Pulverkern 1 muss zur Eindiffusion in das Reaktions-Rohr 3, das die Legierungskomponente X enthält, das Moderations-Rohr 2 durchqueren. Dadurch kann die Eindiffusion des Sn in das Reaktions-Rohr 3 verzögert werden, so dass sich Ausscheidungen von XPk im Reaktions-Rohr bilden können, bevor es zur Ausbildung der Nb3Sn-Phase kommt.

In dieser Ausführungsform ist an der Innenseite der Matrix 5 auch beispielhaft eine Diffusionsbarriere 8 gezeigt, etwa aus Ta, mit der eine Verunreinigung der Matrix 5 durch Eindiffusion von Elementen aus dem Inneren (insbesondere von Sn) und damit eine Verringerung des Restwiderstandsverhältnisses (RRR) der Matrix 5 verhindert werden kann.

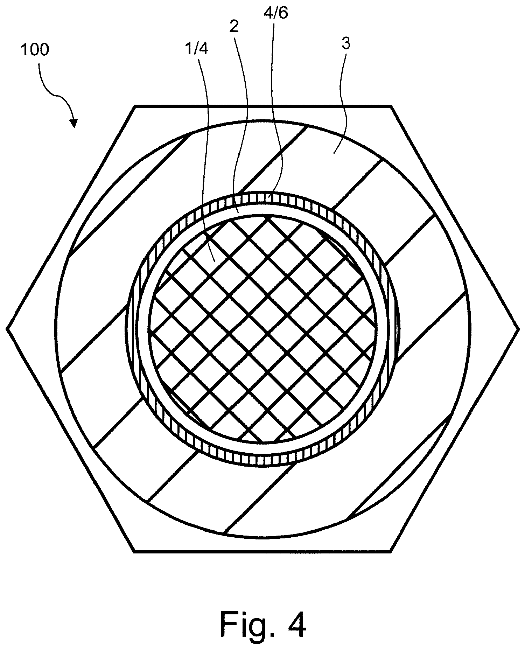

In der Ausführungsform von **Fig. 4** eines erfindungsgemäßen Monofilaments 100 sind zwei Quellen 4 für Partnerkomponente Pk vorgesehen.

Zum einen dient hier der Pulverkern 1 gleichzeitig als Quelle 4 für eine Partnerkomponente Pk, indem der Pulverkern eine entsprechende Pk-haltige chemische Verbindung enthält ist, hier SnO₂-Pulver für Sauerstoff als Partnerkomponente Pk. Zum anderen ist hier um das Moderations-Rohr 2 herum, und innerhalb des Reaktions-Rohrs 3, das die Legierungskomponente X enthält, eine weitere Quelle 4 für eine Partnerkomponente Pk angeordnet. Diese weitere Quelle 4 ist mit einer umlaufenden Pulverschicht 6 ausgebildet, die hier ebenfalls SnO₂-Pulver für Sauerstoff als Partnerkomponente Pk aufweist.

Die Partnerkomponente Pk aus der Pulverschicht 6 erreicht das Reaktions-Rohr 3 während des Reaktionsglühens vor der Partnerkomponente Pk aus dem Pulverkern 1. Hierdurch ist es möglich, die Partnerkomponente Pk sowohl vor der Nb₃Sn-Bildung als auch nach der Nb₃Sn-Bildung in das Reaktions-Rohr 3 (bzw. die daraus entstehenden Strukturen) einzubringen.

In der gezeigten Ausführungsform sind in beiden Quellen 4 gleiche chemische Verbindungen, die die gleiche Partnerkomponente Pk zur Verfügung stellen, vorgesehen. Es ist alternativ auch möglich, in den verschiedenen Quellen 4 verschiedene chemische Verbindungen zur Bereitstellung der Partnerkomponente Pk, oder auch zur Bereitstellung unterschiedlicher Partnerkomponenten Pk (zur Bildung von dann auch unterschiedlichen Ausscheidungen XPk), vorzusehen. Insbesondere kann die Bildung von sowohl oxidischen Ausscheidungen als auch nicht-oxidischen Ausscheidungen im Laufe eines Reaktionsglühens vorgesehen sein.

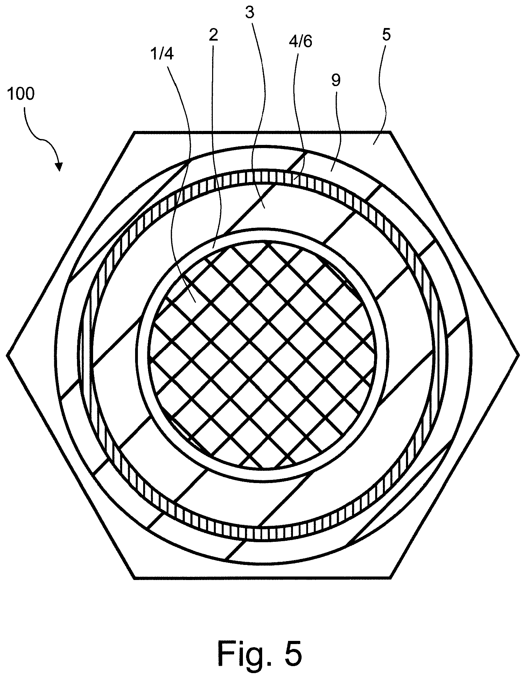

In der Ausführungsform von **Fig. 5** sind ebenfalls zwei Quellen 4 für das dortige Monofilament 100 vorgesehen.

Eine Quelle 4 ist wiederum durch den Pulverkern 1 ausgebildet, dem hier SnO₂-Pulver beigemischt ist. Weiterhin ist eine ringartige Quelle 4 vorgesehen, die hier als Pulverschicht 6 enthaltend SnO₂-Pulver ausgebildet ist und hier das Reaktions-Rohr 3 direkt umschließt. Die Pulverschicht 6 ist wiederum radial außerhalb umschlossen von einem Zusatz-Reaktionsrohr 9, das hier die gleiche Zusammensetzung aufweist wie das Reaktions-Rohr 3, und insbesondere ebenfalls Nb und die Legierungskomponente X enthält.

Bei diesem Aufbau kann Partnerkomponente Pk aus der Pulverschicht 6 sehr schnell sowohl in das Reaktionsrohr 3 als auch in das Zusatz-Reaktions-Rohr 9 gelangen, um dort Ausscheidungen XPk zu bilden, insbesondere vor der Bildung der Nb₃Sn-Phase, um für diese Phase ein feines Gefüge zu bewirken. Die Partnerkomponente Pk aus dem Pulverkern 1 kommt in großen Teilen nach dem Sn aus dem Pulverkern 1 im Reaktionsrohr 3 und im Zusatz-Reaktionsrohr 9 an, um dann punktförmige Ausscheidungen als künstliche Pinningzentren zu bilden. Der Zeitpunkt der Eindiffusion des Sn und von Pk aus dem Pulverkern 1 kann über das Moderations-Rohr 2, insbesondere dessen Wandstärke, geeignet eingestellt werden, ggf. unterstützt von Zusätzen im Pulverkern 1.

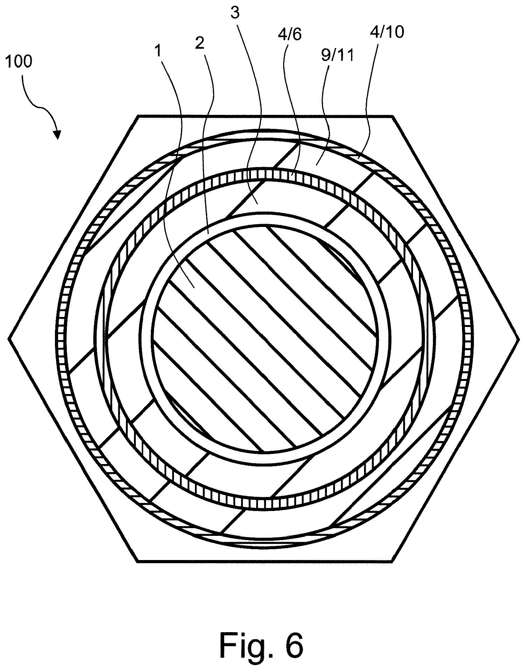

Die Ausführungsform des Monofilaments 100 der **Fig. 6** sieht ebenfalls zwei Quellen 4 vor, die hier beide als ringartige Quellen 4 ausgebildet sind.

Eine der Quellen 4 ist wiederum als Pulverschicht 6 enthaltend SnO₂-Pulver ausgebildet und sitzt unmittelbar radial außen auf dem Reaktions-Rohr 3 auf, so dass Partnerkomponente Pk aus der Pulverschicht 6 schnell in das Reaktions-Rohr 3 eindringen und mit dort vorhandener Legierungskomponente X, hier Zirkon, Ausscheidungen XPk bilden kann, insbesondere bevor die Nb₃Sn-Phase entsteht. Die weitere Quelle 4 für Partnerkomponente Pk ist hier als eine Beschichtung 10 auf der Außenseite des Zusatz-Reaktionsrohrs 9 ausgebildet. Das Zusatz-Reaktionsrohr 9 sitzt wiederum außen direkt auf der Pulverschicht 6 auf. Partnerkomponente Pk aus der Beschichtung 10 erreicht das Reaktions-Rohr 3 später als die Partnerkomponente Pk der Pulverschicht 6.

Durch geeignete Einstellung der Wandstärke des Zusatz-Reaktionsrohrs 9 und der Wandstärke des Moderations-Rohrs 2 kann erreicht werden, dass Sn aus dem Pulverkern 1 das Reaktions-Rohr 3 erreicht, bevor die Partnerkomponente Pk aus der Beschichtung 10 das Reaktions-Rohr 3 erreicht.

Das Zusatz-Reaktions-Rohr 9 hat hier die gleiche Zusammensetzung wie das Reaktions-Rohr 3, enthält also auch Niob und Zirkon, so dass auch das Volumen des Zusatz-Reaktionsrohrs 9 für die Bildung einer Nb₃Sn-Phase genutzt werden kann. Falls gewünscht, kann anstelle des Zusatz-Reaktions-Rohrs 9 auch ein Rohr aus einem Material (etwa Cu) eingesetzt werden, mit dem kein merklicher Beitrag zur Erzeugung von Nb3Sn-Phasenvolumen erfolgt (etwa weil kein oder nur wenig Niob enthalten ist, oder weil das Rohr schlicht relativ dünn ausgebildet ist), mit dem jedoch eine gewünschte Behinderung der Diffusion der Partnerkomponente Pk aus der Beschichtung 10 nach radial innen zum Reaktions-Rohr 3 errreicht wird. In diesem Fall wird dieses Rohr als Hilfs-Moderationsrohr 11 bezeichnet.

Für die Beschichtung 10 eignen sich insbesondere plastisch verformbare oder gut gleitfähige Materialien, da diese bei der Weiterverarbeitung (etwa einem querschnittsreduzierenden Umformprozess) keine Defekte erzeugen. Beispielsweise kann die Beschichtung aus graphitischem Kohlenstoff als Partnerkomponente Pk bestehen, der zusammen mit Fe (Eisen) als Legierungskomponente X im Reaktions-Rohr 3 ein Eisencarbid als Ausscheidung erzeugen kann. In der Pulverschicht 6 können auch nicht plastisch verformbare Materialien, etwa oxidische Pulverpartikel aus SnO₂, genutzt werden, da die Pulverform eine gewisse Fließfähigkeit verleiht. Sauerstoff aus den oxidischen Pulverpartikeln kann beispielsweise mit Zr als Legierungskomponente X im Reaktions-Rohr ZrO2-Ausscheidungen bilden; in diesem Beispiel enthält also das Reaktionsrohr 3 (neben Nb) auch Fe und Zr als zwei Legierungskomponenten X.

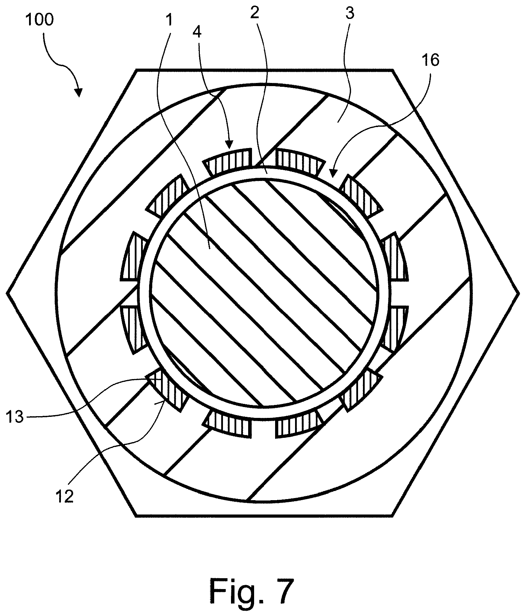

In der **Fig. 7** ist eine Ausführungsform eines Monofilaments 100 gezeigt, bei der an der radialen Innenseite des Reaktions-Rohrs 3 Quelltaschen 12 ausgebildet sind. Die Quelltaschen 12 sind hier Rücksprünge am Reaktions-Rohr 3, die mit einer Pulverfüllung 13 versehen sind. Die Pulverfüllung 13 enthält ein Pulver, das die (wenigstens eine) Partnerkomponente Pk enthält, hier SnO₂-Pulver für die Partnerkomponente Sauerstoff, und hier weiterhin ein metallisches Pulver, etwa Cu-Pulver, um die Umformbarkeit zu verbessern. Die Quelltaschen 12 befinden sich alle an einer einheitlichen (gleichen) radialen Position im Monofilament 100 und stellen mehrere Quellstrukturen dar, die in ihrer Gesamtheit eine ringartige Quelle 4 für die Partnerkomponente Pk im Monofilament 100 ausbilden. In Umfangsrichtung zwischen den Quelltaschen 12 verbleiben radial durchgängige Strukturbereiche 16, hier ausgebildet durch das Reaktions-Rohr 3 und das Moderations-Rohr 2 berührend, die die Verarbeitbarkeit des Monofilaments 100 verbessern.

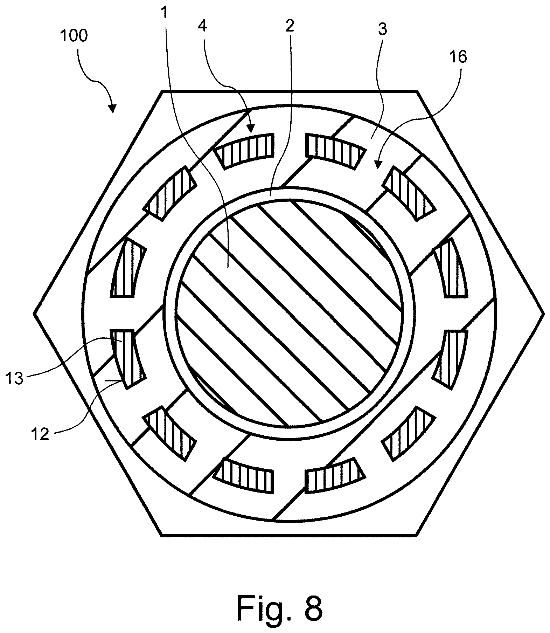

Die Ausführungsform eines Monofilaments 100 von **Fig. 8** zeigt ebenfalls eine ringartige Quelle 4, die aus mehreren Quelltaschen 12 gebildet wird, die sich an einer einheitlichen radialen Position im Monofilament 100 befinden und wiederum mit einer Pulverfüllung 13 versehen sind, die hier SnO₂-Pulver enthält. In der gezeigten Ausführungsform sind die Quelltaschen 12 als allseitig geschlossene Ausnehmungen innerhalb des Reaktions-Rohrs 3 ausgebildet. Zwischen den Quelltaschen 12 verbleiben wiederum radial durchgängige Strukturbereiche 16 im Reaktions-Rohr 3.

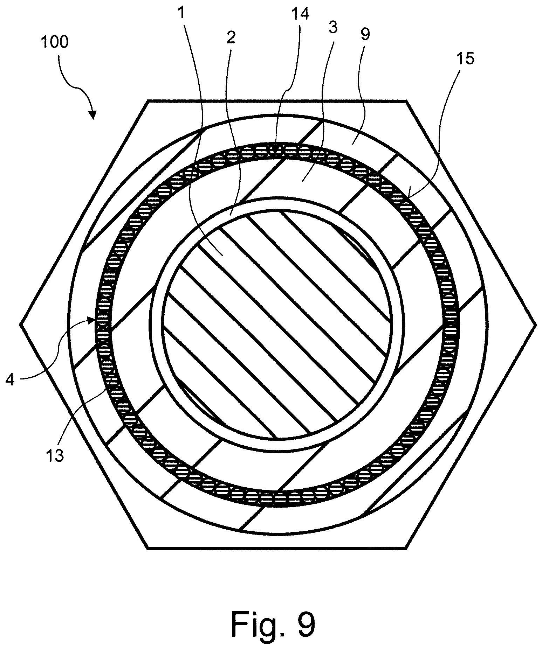

In der in **Fig. 9** gezeigten Ausführungsform eines Monofilaments 100 ist eine ringartige Quelle 4 vorgesehen, die aus einer Vielzahl von Quellröhrchen 14 als Quellstrukturen gebildet wird, die in einem radialen Spalt 15 zwischen dem innen angrenzenden Reaktions-Rohr 3 und dem außen angrenzenden Zusatz-Reaktionsrohr 9 eingebracht sind. Die Quellröhrchen 14 sind hier mit rundem Querschnitt ausgebildet und sind mit einer Pulverfüllung 13 versehen, die ein Pulver enthaltend die wenigstens eine Partnerkomponente Pk enthält. Man beachte, dass nach einem üblichen, querschnittsreduzierenden Umformen die Leerräume zwischen den Quellröhrchen 14 im Spalt 15 durch Material aus dem angrenzenden Reaktions-Rohr 3 und dem angrenzenden Zusatz-Reaktionsrohr 9 verfüllt werden (nicht dargestellt).

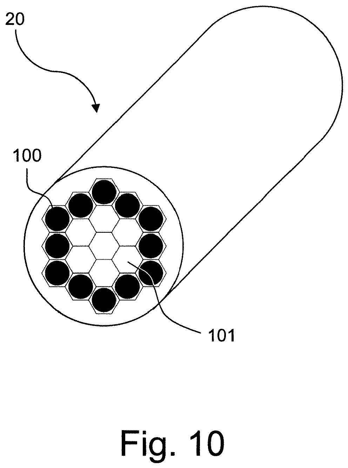

Die **Fig. 10** zeigt ein Halbzeug 20 für einen Nb₃Sn-halatigen Supraleiterdraht für die Erfindung. Das Halbzeug 20 enthält mehrere erfindungsgemäße Monofilamente 100 ("Bündelung"), wobei die Monofilamente 100 hier ringartig angeordnet sind. Das Halbzeug 20 ist hier im Übrigen aus Kupfer gefertigt.

Typischerweise werden im Halbzeug 20 mehrere Monofilamente 100 mit hexagonalem Außenquerschnitt und ggf. (wie hier dargestellt) mehrere Stabilisierungselemente 101 mit gleichem hexagonalen Außenquerschnitt, meist aus Cu oder einer Cu-Legierung, angeordnet, die in hexagonal dichter Packung aneinander liegend in einem Außenrohr platziert werden.

Das Halbzeug 20 wird nach Einbringung der Monofilamente 100 einer querschnittsreduzierenden Umformung unterzogen (ggf. wird auch eine mehrfache Bündelung und querschnittsreduzierende Umformung angewandt), wodurch ein Halbzeugdraht erhalten wird, der anschließend in eine gewünschte Form gewickelt wird, etwa in Form einer Spule.

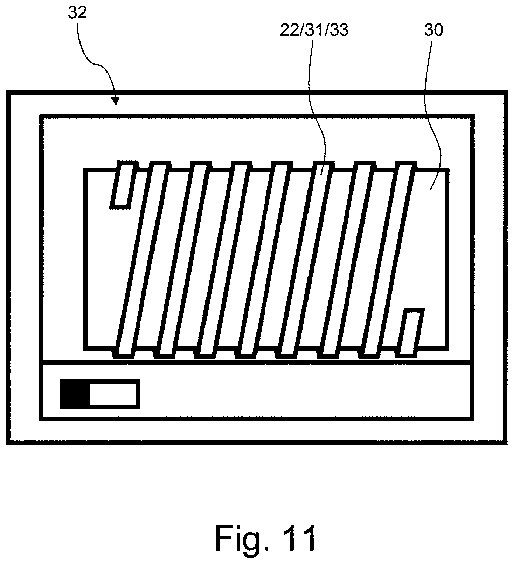

Die **Fig. 11** zeigt den auf einem Spulenkörper 30 zu einer Spule 31 gewickelten Halbzeugdraht 20, angeordnet in einem Ofen 32.

Im Ofen 31 wird der Halbzeugdraht 20 einem Reaktionsglühen unterzogen, typischerweise bei einer Temperatur zwischen 400°C und 800°C; das Reaktionsglühen kann dabei mehrere Tage dauern. Dabei entsteht aus dem Sn der Pulverkerne und dem Nb der Reaktions-Rohre supraleitendes Nb₃Sn, und aus der wenigstens einen Partnerkomponente Pk der wenigstens einen Quelle und der wenigstens einen Legierungskomponente X des Reaktions-Rohrs Ausscheidungen XPk.

Nach dem Reaktionsglühen ist aus dem Halbzeugdraht 22 ein Nb₃Sn-haltiger Supraleiterdraht 33 entstanden, wobei in dessen Nb₃Sn-Phase auch die Ausscheidungen XPk enthalten sind. Der Supraleiterdraht 33 weist eine besonders hohe supraleitende Stromtragfähigkeit auf.

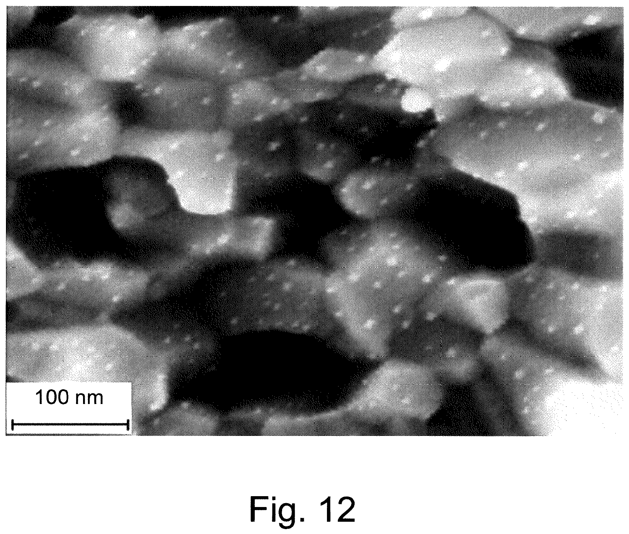

Die **Fig. 12** zeigt eine SEM-Aufnahme der Nb₃Sn-Phase eines gemäß der Erfindung gefertigten Supraleiterdrahts. Das zugehörige Monofilament enthielt im Pulverkern SnO₂-Pulver als Sauerstoffquelle, wobei der Pulverkern in einem Moderations-Rohr aus Kupfer eingeschlossen war. Das umgebenden Reaktionsrohr bestand aus einer NbZr1-Legierung. Das Reaktionsglühen sah eine Behandlungsdauer von 300 h bei einem mehrstufigen Temperaturprogramm mit einer Maximaltemperatur von 640°C vor. Der Drahtdurchmesser betrug 1 mm, und der Durchmesser eines Monofilaments im Supraleiterdraht 40 µm. Deutlich sind ZrO₂-Ausscheidungen(helle Punkte) auf den Nb₃Sn-Körnern zu erkennen, die als künstliche Pinningzentren wirken können. Die Nb₃Sn-Körner weisen typischerweise Durchmesser um 30-80 nm auf. Bei einem Kontrollversuch, bei dem der Pulverkern kein SnO₂ enthielt, wurden keine Ausscheidungen und ein gröberes Gefüge beobachtet (nicht dargestellt).

Zusammenfassend betrifft die Erfindung ein Monofilament für einen Powder-in-tube Halbzeugdraht für einen Nb3Sn-haltigen Supraleiterdraht, mit einem Sn-haltigen Pulverkern angeordnet radial innerhalb eines Nb-haltigen Reaktions-rohrs, wobei das Monofilament für die Bildung von Ausscheidungen XPk im Bereich der Nb₃Sn-Phase beim Reaktionsglühen eingerichtet ist. Das Monofilament enthält wenigstens eine Quelle für wenigstens eine Partnerkomponente Pk, und das Reaktions-Rohr ist mit wenigstens einer Legierungskomponente X versetzt, so dass beim Reaktionsglühen die Ausscheidungen XPk im Bereich des Reaktions-Rohrs gebildet werden können. Der Pulverkern ist in einem Moderations-Rohr enthalten, um die Abgabe des Sn an das Reaktions-Rohr und damit die Nb₃Sn-Bildung zu kontrollieren (insbesondere zu verzögern) und zusammen mit dem Aufbau des Monofilaments insgesamt zeitlich auf die Bildung der Ausscheidungen abzustimmen, insbesondere so dass Ausscheidungen zumindest vor und bevorzugt auch nach Bildung der Nb₃Sn-Phase gebildet werden. Bevorzugt ist das Monofilament so ausgebildet (und das Reaktionsglühen so eingerichtet), dass beim Reaktionsglühen Partnerkomponente Pk das Reaktions-Rohr in wenigstens zwei zeitlich aufeinanderfolgenden Wellen erreicht, insbesondere wobei eine Welle hauptsächlich vor der Bildung der Nb₃Sn-Phase das Reaktions-Rohr erreicht, und eine Welle hauptsächlich nach der Bildung der Nb₃Sn-Phase das Reaktions-Rohr erreicht. Hierfür kann das Monofilament insbesondere wenigstens zwei separate Quellen für Partnerkomponente Pk an unterschiedlichen radialen Positionen aufweisen, oder wenigstens zwei unterschiedliche chemische Verbindungen in der wenigstens einen Quelle aufweisen, die jeweils Partnerkomponente Pk bei unterschiedlichen Temperaturen abgeben, oder in der wenigstens einen Quelle eine chemische Verbindung aufweisen, die Partnerkomponente Pk zweistufig bei unterschiedlichen Temperaturen, also über eine Zwischenstufe, abgibt.

### Bezugszeichenliste

- 1: Pulverkern
- 2: Moderations-Rohr
- 3: Reaktions-Rohr
- 4: Quelle
- 5: Matrix
- 6: Pulverschicht
- 7: Zusatz-Moderationsrohr
- 8: Diffusionsbarriere
- 9: Zusatz-Reaktionsrohr
- 10: Beschichtung
- 11: Hilfs-Moderationsrohr
- 12: Quelltaschen
- 13: Pulverfüllung
- 14: Quellröhrchen
- 15: Spalt
- 16: radial durchgängiger Strukturbereich
- 20: Halbzeug
- 22: Halbzeugdraht
- 30: Spulenkörper
- 31: Spule
- 32: Ofen
- 33: Supraleiterdraht
- 100: Monofilament
- 101: Stabilisierungselement
- DP: Durchmesser Pulverkern
- WM: Wandstärke Moderations-Rohr
- WR: Wandstärke Reaktions-Rohr

## Patentansprüche

1. Monofilament (100) zur Herstellung eines Nb₃Sn-haltigen Supraleiterdrahts (33),
wobei das Monofilament (100) umfasst:
- einen Pulverkern (1), enthaltend ein Sn-haltiges Pulver,
- ein Reaktions-Rohr (3) aus einer Nb-Legierung, enthaltend Nb und wenigstens eine weitere Legierungskomponente X,
wobei der Pulverkern (1) innerhalb des Reaktions-Rohrs (3) angeordnet ist,
wobei im Monofilament (100) weiterhin wenigstens eine Quelle (4) für wenigstens eine Partnerkomponente *Pk* enthalten ist,
wobei eine jeweilige Quelle (4) eine oder mehrere Quellstrukturen an einer einheitlichen radialen Position im Monofilament (100) umfasst; wobei die Legierungskomponente X und die Partnerkomponente Pk so gewählt sind, dass sie bei einem Reaktionsglühen des Monofilaments (100), bei dem Sn aus dem Pulverkern (1) und Nb aus dem Reaktions-(3) zu Nb₃Sn reagieren, Ausscheidungen XPk bilden,
**dadurch gekennzeichnet,**
**dass** der Pulverkern (1) in einem Moderations-Rohr (2) angeordnet ist, und dass das Moderations-Rohr (2) innerhalb des Reaktions-Rohrs (3) angeordnet ist.

2. Monofilament (100) nach Anspruch 1, **dadurch gekennzeichnet, dass** im Monofilament (100) wenigstens zwei an unterschiedlichen radialen Positionen angeordnete Quellen (4) für die wenigstens eine Partnerkomponente Pk enthalten sind.

3. Monofilament (100) nach Anspruch 1 oder 2, **dadurch gekennzeichnet, dass** das Moderations-Rohr (2) ganz oder teilweise aus Cu oder einer Cu-Legierung oder Ag oder einer Ag-Legierung oder Sn oder einer Sn-Legierung oder Nb oder einer Nb-Legierung gefertigt ist.

4. Monofilament (100) nach einem der vorhergehenden Ansprüche, **dadurch gekennzeichnet, dass** die wenigstens eine Quelle (4) für die wenigstens eine Partnerkomponente Pk ein Pulver umfasst.

5. Monofilament (100) nach einem der vorhergehenden Ansprüche, **dadurch gekennzeichnet,**
**dass** die wenigstens eine Quelle (4) für die wenigstens eine Partnerkomponente *Pk* ein im Pulverkern (1) enthaltenes Pulver umfasst,
und **dass** die Wandstärke WM des Moderations-Rohrs (2) gewählt ist mit WM ≤ 0,075^{∗}DP und/oder WM ≤ 0,2^{∗}WR
mit DP: Durchmesser des Pulverkerns (1) und WR: Wandstärke des Reaktions-Rohrs (3).

6. Monofilament (100) nach Anspruch 5, **dadurch gekennzeichnet, dass** die Quelle (4), die ein im Pulverkern (1) enthaltenes Pulver umfasst, als Partnerkomponente *Pk* Sauerstoff enthält, und das Moderations-Rohr (2) aus Cu oder einer Cu-Legierung gefertigt ist.

7. Monofilament (100) nach einem der Ansprüche 5 oder 6, **dadurch gekennzeichnet, dass** der Pulverkern (1) Cu, Ag und/oder Sn enthält, insbesondere elementares Cu, Ag und/oder Sn enthält.

8. Monofilament (100) nach einem der vorhergehenden Ansprüche, **dadurch gekennzeichnet, dass** die wenigstens eine Quelle (4) für die wenigstens eine Partnerkomponente Pk eine ringartige Quelle (4) umfasst, wobei das Moderations-Rohr (2) radial innerhalb der ringartigen Quelle (4) angeordnet ist.

9. Monofilament (100) nach Anspruch 8, **dadurch gekennzeichnet, dass** die ringartige Quelle (4) ein Pulver in einer umlaufenden Pulverschicht (6) umfasst.

10. Monofilament (100) nach Anspruch 8, **dadurch gekennzeichnet, dass** die ringartige Quelle (4) ein Pulver in einer Pulverfüllung (13) von ringartig angeordneten Quellröhrchen (14) oder Quelltaschen (12) umfasst, wobei die Quelltaschen (12) in einer zu der ringartigen Quelle (4) benachbarten Struktur des Monofilaments (100) ausgebildet sind.

11. Monofilament (100) nach Anspruch 9 oder 10, **dadurch gekennzeichnet, dass** die Pulverschicht (6) oder die Pulverfüllung (12) ein metallisches Pulver enthält,
insbesondere wobei das metallische Pulver elementares Cu oder eine Cu-Legierung oder Ag oder eine Ag-Legierung enthält.

12. Monofilament (100) nach Anspruch 8, **dadurch gekennzeichnet, dass** die ringartige Quelle (4) eine umlaufende Beschichtung (10) einer zur ringartigen Quelle (4) benachbarten Struktur des Monofilaments (100) umfasst, insbesondere wobei die benachbarte Struktur das Reaktions-Rohr (3) oder das Moderations-Rohr (2) ist.

13. Monofilament (100) nach einem der Ansprüche 8 bis 12, **dadurch gekennzeichnet, dass** das Reaktions-Rohr (3) radial innerhalb der ringartigen Quelle (4) angeordnet ist, insbesondere wobei die ringartige Quelle (4) das Reaktions-Rohr (3) außen direkt umschließt.

14. Monofilament (100) nach Anspruch 13, **dadurch gekennzeichnet,**
**dass** das Monofilament (100) ein Zusatz-Reaktionsrohr (9) umfasst, wobei das Zusatz-Reaktionsrohr (9) Nb enthält,
insbesondere wobei das Zusatz-Reaktionsrohr (9) weiterhin auch die mindestens eine weitere Legierungskomponente X enthält,
und **dass** die ringartige Quelle (4) radial innerhalb des Zusatz-Reaktionsrohrs (9) angeordnet ist,
insbesondere wobei das Zusatz-Reaktionsrohr (9) die ringartige Quelle (4) außen direkt umschließt.

15. Monofilament (100) nach einem der Ansprüche 8 bis 12, **dadurch gekennzeichnet, dass** die ringartige Quelle (4) radial außerhalb des Moderations-Rohrs (2) und radial innerhalb des Reaktions-Rohrs (3) angeordnet ist.

16. Monofilament (100) nach Anspruch 15, **dadurch gekennzeichnet,**
**dass** das Monofilament (100) weiterhin ein Zusatz-Moderationsrohr (7) umfasst,
und **dass** die ringartige Quelle (4) radial innerhalb des Zusatz-Moderationsrohrs (7) angeordnet ist, und das Zusatz-Moderationsrohr (7) radial innerhalb des Reaktions-Rohrs (3) angeordnet ist,
insbesondere wobei das Zusatz-Moderationsrohr (7) die ringartige Quelle (4) außen direkt umschließt.

17. Monofilament (100) nach einem der vorhergehenden Ansprüche, **dadurch gekennzeichnet, dass** die wenigstens eine Quelle (4) eine erste chemische Verbindung und eine zweite chemische Verbindung jeweils enthaltend die gleiche Partnerkomponente Pk enthält, wobei unter Wärmebehandlung die erste chemische Verbindung die Partnerkomponente Pk bei einer niedrigeren Temperatur freisetzt als die zweite chemische Verbindung.

18. Monofilament (100) nach einem der vorhergehenden Ansprüche, **dadurch gekennzeichnet, dass** die wenigstens eine Partnerkomponente *Pk* Sauerstoff umfasst, und die wenigstens eine Legierungskomponente X ein Metall umfasst, das unedler als Nb ist.

19. Monofilament (100) nach Anspruch 18, **dadurch gekennzeichnet,**
**dass** die Quelle (4) für die wenigstens eine Partnerkomponente Pk ein Pulver enthaltend ein Metalloxid umfasst, insbesondere wobei das Metalloxid SnO, SnO₂, CuO, Cu₂O, AgO, Ag₂O, Ag₂O₃, Na₂O₂, CaO₂, ZnO₂, MgO₂, NbO₂ oder Nb₂O₅ ist,
und/oder dass wenigstens eine Legierungskomponente X eines oder mehrere der Elemente Mg, AI, V, Zr, Ti, Gd oder Hf umfasst.

20. Monofilament (100) nach einem der vorhergehenden Ansprüche, **dadurch gekennzeichnet, dass** die Ausscheidungen XPk nicht-oxidische Ausscheidungen umfassen, insbesondere ausschließlich nicht-oxidische Ausscheidungen sind.

21. Verfahren zur Herstellung eines Supraleiterdrahts (33),
wobei mehrere Monofilamente (100) nach einem der vorhergehenden Ansprüche einstufig oder mehrstufig gebündelt und umgeformt werden, wodurch ein Halbzeugdraht (22) erhalten wird,
und wobei der Halbzeugdraht (22) in eine gewünschte Form gebracht, insbesondere gewickelt, und einem Reaktionsglühen unterzogen wird, wobei aus der wenigstens einen Legierungskomponente X und der wenigstens einen Partnerkomponente *Pk* Ausscheidungen XPk gebildet werden und aus dem Nb der Reaktions-Rohre (3) und dem Sn der Pulverkerne (1) Nb₃Sn gebildet wird.

## Claims

1. A monofilament (100) for producing an Nb₃Sn-containing superconductor wire (33),
where the monofilament (100) comprises:
- a powder core (1) comprising an Sn-containing powder,
- a reaction tube (3) composed of an Nb alloy comprising Nb and at least one further alloy component X,
where the powder core (1) is disposed within the reaction tube (3), where the monofilament (100) further comprises at least one source (4) for at least one partner component *Pk,*
where a respective source (4) comprises one or more source structures at a unitary radial position in the monofilament (100);
where the alloy component X and the partner component *Pk* are selected such that they form precipitates XPk on a reaction annealing of the monofilament (100) in which Sn from the powder core (1) and Nb from the reaction tube (3) react to give Nb₃Sn,
**characterized in that**
the powder core (1) is disposed in a moderation tube (2),
and that the moderation tube (2) is disposed within the reaction tube (3).

2. The monofilament (100) as claimed in claim 1, **characterized in that** the monofilament (100) comprises at least two sources (4), disposed at different radial positions, for the at least one partner component Pk.

3. The monofilament (100) as claimed in claim 1 or 2, **characterized in that** the moderation tube (2) is fabricated wholly or partly of Cu or a Cu alloy or Ag or an Ag alloy or Sn or an Sn alloy or Nb or an Nb alloy.

4. The monofilament (100) as claimed in any of the preceding claims, **characterized in that** the at least one source (4) for the at least one partner component Pk comprises a powder.

5. The monofilament (100) as claimed in any of the preceding claims, **characterized in**
**that** the at least one source (4) for the at least one partner component *Pk* comprises a powder present in the powder core (1),
and **that** the wall thickness WM of the moderation tube (2) is selected with
WM ≤ 0.075^{∗}DP and/or WM ≤ 0.2^{∗}WR
where DP is the diameter of the powder core (1) and WR is the wall thickness of the reaction tube (3).

6. The monofilament (100) as claimed in claim 5, **characterized in that** the source (4) which comprises a powder present in the powder core (1) comprises oxygen as partner component *Pk,* and the moderation tube (2) is fabricated of Cu or a Cu alloy.

7. The monofilament (100) as claimed in claim 5 or 6, **characterized in that** the powder core (1) comprises Cu, Ag and/or Sn, more particularly elemental Cu, Ag and/or Sn.

8. The monofilament (100) as claimed in any of the preceding claims, **characterized in that** the at least one source (4) for the at least one partner component Pk comprises an annular source (4), where the moderation tube (2) is disposed radially within the annular source (4).

9. The monofilament (100) as claimed in claim 8, **characterized in that** the annular source (4) comprises a powder in a circumferential powder layer (6).

10. The monofilament (100) as claimed in claim 8, **characterized in that** the annular source (4) comprises a powder in a powder filling (13) of annularly disposed source tubules (14) or source pockets (12), where the source pockets (12) are configured in a structure of the monofilament (100) adjacent to the annular source (4).

11. The monofilament (100) as claimed in claim 9 or 10, **characterized in that** the powder layer (6) or the powder filling (12) comprises a metallic powder,
in particular where the metallic powder comprises elemental Cu or a Cu alloy or Ag or an Ag alloy.

12. The monofilament (100) as claimed in claim 8, **characterized in that** the annular source (4) comprises a circumferential coating (10) of a structure of the monofilament (100) adjacent to the annular source (4), in particular where the adjacent structure is the reaction tube (3) or the moderation tube (2).

13. The monofilament (100) as claimed in any of claims 8 through 12, **characterized in that** the reaction tube (3) is disposed radially within the annular source (4), in particular where the annular source (4) externally directly surrounds the reaction tube (3).

14. The monofilament (100) as claimed in claim 13, **characterized in that** the monofilament (100) comprises an ancillary reaction tube (9), where the ancillary reaction tube (9) comprises Nb,
in particular where the ancillary reaction tube (9) further comprises the at least one further alloy component X as well,
and that the annular source (4) is disposed radially within the ancillary reaction tube (9),
in particular where the ancillary reaction tube (9) externally directly surrounds the annular source (4).

15. The monofilament (100) as claimed in any of claims 8 through 12, **characterized in that** the annular source (4) is disposed radially outside the moderation tube (2) and radially within the reaction tube (3).

16. The monofilament (100) as claimed in claim 15, **characterized in that** the monofilament (100) further comprises an ancillary moderation tube (7), and that the annular source (4) is disposed radially within the ancillary moderation tube (7), and the ancillary moderation tube (7) is disposed radially within the reaction tube (3),
in particular where the ancillary moderation tube (7) externally directly surrounds the annular source (4).

17. The monofilament (100) as claimed in any of the preceding claims, **characterized in that** the at least one source (4) comprises a first chemical compound and a second chemical compound, each comprising the same partner component Pk, where on heat treatment the first chemical compound releases the partner component Pk at a lower temperature than the second chemical compound.

18. The monofilament (100) as claimed in any of the preceding claims, **characterized in that** the at least one partner component *Pk* comprises oxygen, and the at least one alloy component X comprises a metal which is less noble than Nb.

19. The monofilament (100) as claimed in claim 18, **characterized in that** the source (4) for the at least one partner component Pk comprises a powder comprising a metal oxide, in particular where the metal oxide is SnO, SnO₂, CuO, Cu₂O, AgO, Ag₂O, Ag₂O₃, Na₂O₂, CaO₂, ZnO₂, MgO₂, NbO₂ or Nb₂O₅, and/or that at least one alloy component X comprises one or more of the elements Mg, Al, V, Zr, Ti, Gd or Hf.

20. The monofilament (100) as claimed in any of the preceding claims, **characterized in that** the precipitates XPk comprise nonoxidic precipitates, more particularly are exclusively nonoxidic precipitates.

21. A method for producing a superconductor wire (33),
where a plurality of monofilaments (100) as claimed in any of the preceding claims is subjected to single-stage or multistage bundling and reshaping, to give a precursor wire (22),
and where the precursor wire (22) is brought into a desired shape, more particularly by winding, and is subjected to a reaction annealing, where precipitates XPk are formed from the at least one alloy component X and the at least one partner component *Pk,* and Nb₃Sn is formed from the Nb of the reaction tubes (3) and the Sn of the powder cores (1).

## Revendications

1. Monofilament (100) pour la fabrication d'un fil supraconducteur contenant du Nb₃Sn (33),
le monofilament (100) comprenant :
- un noyau de poudre (1), contenant une poudre contenant du Sn,
- un tube de réaction (3) en un alliage de Nb, contenant du Nb et au moins un autre composant d'alliage X,
le noyau de poudre (1) étant agencé à l'intérieur du tube de réaction (3),
au moins une source (4) pour au moins un composant partenaire *Pk* étant en outre contenue dans le monofilament (100),
une source respective (4) comprenant une ou plusieurs structures de source à une position radiale uniforme dans le monofilament (100) ;
le composant d'alliage X et le composant partenaire Pk étant choisis de telle sorte qu'ils forment des précipités XPk lors d'un recuit de réaction du monofilament (100), lors duquel du Sn provenant du noyau de poudre (1) et du Nb provenant du tube de réaction (3) réagissent pour former du Nb₃Sn, **caractérisé en ce que**
le noyau de poudre (1) est agencé dans un tube de modération (2), et **en ce que** le tube de modération (2) est agencé à l'intérieur du tube de réaction (3).

2. Monofilament (100) selon la revendication 1, **caractérisé en ce qu'**au moins deux sources (4), agencées à des positions radiales différentes, pour l'au moins un composant partenaire Pk sont contenues dans le monofilament (100).

3. Monofilament (100) selon la revendication 1 ou 2, **caractérisé en ce que** le tube de modération (2) est fabriqué entièrement ou partiellement en Cu ou en un alliage de Cu ou en Ag ou en un alliage d'Ag ou en Sn ou en un alliage de Sn ou en Nb ou en un alliage de Nb.

4. Monofilament (100) selon l'une quelconque des revendications précédentes, **caractérisé en ce que** l'au moins une source (4) pour l'au moins un composant partenaire Pk comprend une poudre.

5. Monofilament (100) selon l'une quelconque des revendications précédentes, **caractérisé en ce que** l'au moins une source (4) pour l'au moins un composant partenaire Pk comprend une poudre contenue dans le noyau de poudre (1),
et **en ce que** l'épaisseur de paroi WM du tube de modération (2) est choisie avec WM ≤ 0,075*DP et/ou WM ≤ 0,2*WR
avec DP : diamètre du noyau de poudre (1) et WR : épaisseur de paroi du tube de réaction (3).

6. Monofilament (100) selon la revendication 5, **caractérisé en ce que** la source (4), qui comprend une poudre contenue dans le noyau de poudre (1), contient de l'oxygène en tant que composant partenaire Pk, et le tube de modération (2) est fabriqué en Cu ou en un alliage de Cu.

7. Monofilament (100) selon l'une quelconque des revendications 5 ou 6, **caractérisé en ce que** le noyau de poudre (1) contient du Cu, de l'Ag et/ou du Sn, notamment du Cu, de l'Ag et/ou du Sn élémentaire.

8. Monofilament (100) selon l'une quelconque des revendications précédentes, **caractérisé en ce que** l'au moins une source (4) pour l'au moins un composant partenaire Pk comprend une source annulaire (4), le tube de modération (2) étant agencé radialement à l'intérieur de la source annulaire (4).

9. Monofilament (100) selon la revendication 8, **caractérisé en ce que** la source annulaire (4) comprend une poudre dans une couche de poudre circonférentielle (6) .

10. Monofilament (100) selon la revendication 8, **caractérisé en ce que** la source annulaire (4) comprend une poudre dans un remplissage de poudre (13) de petits tubes de source (14) ou de poches de source (12) agencés de manière annulaire, les poches de source (12) étant formées dans une structure du monofilament (100) voisine de la source annulaire (4).

11. Monofilament (100) selon la revendication 9 ou 10, **caractérisé en ce que** la couche de poudre (6) ou le remplissage de poudre (12) contient une poudre métallique,
la poudre métallique contenant notamment du Cu élémentaire ou un alliage de Cu ou de l'Ag ou un alliage d'Ag.

12. Monofilament (100) selon la revendication 8, **caractérisé en ce que** la source annulaire (4) comprend un revêtement circonférentiel (10) d'une structure du monofilament (100) voisine de la source annulaire (4), la structure voisine étant notamment le tube de réaction (3) ou le tube de modération (2).

13. Monofilament (100) selon l'une quelconque des revendications 8 à 12, **caractérisé en ce que** le tube de réaction (3) est agencé radialement à l'intérieur de la source annulaire (4), la source annulaire (4) entourant notamment directement le tube de réaction (3) à l'extérieur.

14. Monofilament (100) selon la revendication 13, **caractérisé en ce que** le monofilament (100) comprend un tube de réaction supplémentaire (9), le tube de réaction supplémentaire (9) contenant du Nb,
le tube de réaction supplémentaire (9) contenant notamment en outre également l'au moins un autre composant d'alliage X,
et **en ce que** la source annulaire (4) est agencée radialement à l'intérieur du tube de réaction supplémentaire (9),
le tube de réaction supplémentaire (9) entourant notamment directement la source annulaire (4) à l'extérieur.

15. Monofilament (100) selon l'une quelconque des revendications 8 à 12, **caractérisé en ce que** la source annulaire (4) est agencée radialement à l'extérieur du tube de modération (2) et radialement à l'intérieur du tube de réaction (3).

16. Monofilament (100) selon la revendication 15, **caractérisé en ce que** le monofilament (100) comprend en outre un tube de modération supplémentaire (7),
et **en ce que** la source annulaire (4) est agencée radialement à l'intérieur du tube de modération supplémentaire (7), et le tube de modération supplémentaire (7) est agencé radialement à l'intérieur du tube de réaction (3),
le tube de modération supplémentaire (7) entourant notamment directement la source annulaire (4) à l'extérieur.

17. Monofilament (100) selon l'une quelconque des revendications précédentes, **caractérisé en ce que** l'au moins une source (4) contient un premier composé chimique et un deuxième composé chimique, chacun contenant le même composant partenaire Pk ; sous traitement thermique, le premier composé chimique libérant le composant partenaire Pk à une température plus basse que le deuxième composé chimique.

18. Monofilament (100) selon l'une quelconque des revendications précédentes, **caractérisé en ce que** l'au moins un composant partenaire Pk comprend de l'oxygène, et l'au moins un composant d'alliage X comprend un métal qui est moins noble que Nb.

19. Monofilament (100) selon la revendication 18, **caractérisé en ce que** la source (4) pour l'au moins un composant partenaire Pk comprend une poudre contenant un oxyde métallique, l'oxyde métallique étant notamment SnO, SnO₂, CuO, Cu₂O, AgO, Ag₂O, Ag₂O₂, Ag₂O₃, CaO₂, ZnO₂, MgO₂, NbO₂ ou Nb₂O₅,
et/ou **en ce qu'**au moins un composant d'alliage X comprend un ou plusieurs des éléments Mg, Al, V, Zr, Ti, Gd ou Hf.

20. Monofilament (100) selon l'une quelconque des revendications précédentes, **caractérisé en ce que** les précipités XPk comprennent des précipités non oxydiques, notamment sont exclusivement des précipités non oxydiques.

21. Procédé de fabrication d'un fil supraconducteur (33),
plusieurs monofilaments (100) selon l'une quelconque des revendications précédentes étant regroupés et façonnés en une étape ou en plusieurs étapes, ce qui permet d'obtenir un fil semi-fini (22),
et le fil semi-fini (22) étant mis sous une forme souhaitée, notamment enroulé, et soumis à un recuit de réaction, des précipités XPk étant formés à partir de l'au moins un composant d'alliage X et de l'au moins un composant partenaire Pk, et du Nb₃Sn étant formé à partir du Nb des tubes de réaction (3) et du Sn des noyaux de poudre (1).
